# EUROPEAN PATENT APPLICATION

(11) **EP 4 438 201 A1**
(43) Date of publication of application: **02.10.2024**
(21) Application number: 22895502.7
(22) Date of filing: 09.11.2022
(51) Int. Cl.: B22F 1/16, B22F 1/00, B22F 1/14, B22F 3/00, C22C 38/00, C23C 22/07, H01F 1/059, H01F 1/06, H01F 1/08

(54) **METHOD FOR MANUFACTURING MAGNETIC POWDER, MAGNETIC FIELD-AMPLIFYING MAGNETIC MATERIAL, AND ULTRA HIGH FREQUENCY-ABSORBING MAGNETIC MATERIAL**

(30) Priority: 22.11.2021 JP 2021189558; 28.02.2022 JP 2022029942
(71) Applicant: Nichia Corporation, Anan-shi, Tokushima 774-8601 (JP)
(72) Inventor: AKAMATSU, Jun, Anan-shi, Tokushima 774-8601 (JP); ABE, Satoshi, Anan-shi, Tokushima 774-8601 (JP); ABE, Masahiro, Anan-shi, Tokushima 774-8601 (JP); IWAI, Kenta, Anan-shi, Tokushima 774-8601 (JP); YAMANAKA, Satoshi, Anan-shi, Tokushima 774-8601 (JP); TADA, Shuichi, Anan-shi, Tokushima 774-8601 (JP); IMAOKA, Nobuyoshi, Anan-shi, Tokushima 774-8601 (JP)
(74) Representative: Vossius & Partner Patentanwälte Rechtsanwälte mbB
(86) International application number: PCT/JP2022/041715
(87) International publication number: WO 2023/090220

(57) **Abstract**

Provided are a magnetic powder having good high-frequency characteristics with low iron loss and good efficiency even at high frequencies, a method of producing a magnetic powder having good high-frequency characteristics with small degradation due to eddy currents and good absorption characteristics even at hyper-high frequencies, a magnetic material for magnetic field amplification having magnetic field amplification characteristics at high frequencies, and a magnetic material for hyper-high frequency absorption. Included is a method of producing a magnetic powder which includes performing a phosphorus treatment to obtain a phosphorus compound and a rare earth-iron-nitrogen-based magnetic powder, the phosphorus treatment including adding an inorganic acid to a slurry containing: a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of a total R content; water; and a phosphorus-containing substance. Also included are a magnetic material for magnetic field amplification and a magnetic material for hyper-high frequency absorption each of which contains a phosphorus compound and a rare earth-iron-nitrogen-based magnetic powder.

## Description

### TECHNICAL FIELD

The present disclosure relates to a method of producing a magnetic powder, a magnetic material for magnetic field amplification, and a magnetic material for hyper-high frequency absorption.

### BACKGROUND ART

In recent years, as devices have become more compact and multifunctional and computing speeds have increased, the driving frequency has been increasing, and the use of high or hyper-high frequency based devices has grown steadily. Particularly noteworthy is the progress of power devices used in the high frequency range of at least 1 MHz but lower than 1 GHz. For example, the market for GaN electronic devices as devices for high-frequency, high-output wireless applications or for power electronics is expected to significantly grow in the future. Higher-frequency GaN circuits for power electronics require not only higher-frequency GaN devices but also higher-frequency passive components. For example, GaN contactless power transfer uses a frequency of higher than 10 MHz and needs coils including magnetic core materials that can follow high frequencies. At present, however, due to the lack of magnetic core materials with good high-frequency characteristics, there is no choice but to use air-core coils, which disadvantageously increase the overall circuit size, even if devices can be downsized by using GaN for higher frequency applications.

Also noteworthy is the progress of information infrastructures in the hyper-high frequency range of 1 GHz to 1 THz. There are various needs for high-frequency characteristics of materials which can absorb signals in the frequency range of at least 1 GHz but lower than 10 GHz for 5G, of at least 10 GHz but lower than 100 GHz for 5G+, or of 100 GHz to 1 THz for 6G, and their harmonics and other spurious signals. These needs have recently been increasing. Particularly, no material currently exists that can absorb a wide range of hyper-high frequencies of 1 GHz or more or even 10 GHz or more, and there are great expectations for the development of very broad frequency band hyper-high frequency absorbing materials which can be widely used in the frequency range of 1 GHz to 1 THz. Examples of high frequency magnetic materials known to date include a rare earth-iron-nitrogen-based magnetic material including a powder having a surface coated with a ferrite-based magnetic material (Patent Literature 1).

### CITATION LIST

### - Patent Literature

Patent Literature 1: WO 2008/136391

### SUMMARY OF INVENTION

### - Technical Problem

However, the material disclosed in Patent Literature 1 is not efficient enough to be applied to materials for magnetic field amplification in the frequency range of 1 MHz to 1 THz described above. Also, the material does not have high-frequency characteristics which can meet the needs of very broad frequency band absorbing materials in the hyper-high frequency range.

The present disclosure aims to provide a magnetic powder having good high-frequency characteristics with low iron loss and good efficiency even at high frequencies, a method of producing a magnetic powder having good high-frequency characteristics with small degradation due to eddy currents and good absorption characteristics even at hyper-high frequencies, and a magnetic material for magnetic field amplification having magnetic field amplification characteristics at high frequencies.

### - Solution to Problem

A method of producing a magnetic powder according to an aspect of the present disclosure includes performing a phosphorus treatment to obtain a phosphorus compound and a rare earth-iron-nitrogen-based magnetic powder, the phosphorus treatment including adding an inorganic acid to a slurry containing: a rare earth-iron-nitrogen-based magnetic powder containing R, Fe, and N, where R represents at least one of rare earth elements selected from the group consisting of Y, Ce, Pr, Nd, Gd, Tb, Dy, Ho, Er, Tm, Lu, and Sm, and if R contains Sm, Sm constitutes less than 50 atm% of a total R content; water; and a phosphorus-containing substance.

Further, a magnetic material for magnetic field amplification or a magnetic material for hyper-high frequency absorption according to an aspect of the present disclosure contains a phosphorus compound and a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of a total R content.

### - Advantageous Effects of Invention

The present disclosure allows for providing a magnetic powder with good efficiency in a high frequency range, as well as a method of producing a magnetic powder with good absorption characteristics in a hyper-high frequency range, a magnetic material for magnetic field amplification with magnetic field amplification characteristics, and a magnetic material for hyper-high frequency absorption.

### BRIEF DESCRIPTION OF DRAWINGS

FIG. 1A shows a scanning transmission electron microscopic (STEM) image of a cross-section of a phosphorus compound-coated rare earth-iron-nitrogen-based magnetic powder prepared in Example 1.
FIG. 1B shows a STEM image of a cross-section of a phosphorus compound-coated rare earth-iron-nitrogen-based magnetic powder prepared in Example 2.
FIG. 1C shows a STEM image of a cross-section of a phosphorus compound-coated rare earth-iron-nitrogen-based magnetic powder prepared in Comparative Example 1.
FIG. 2A shows, on the left side, a transmission electron microscopic (TEM) image of a cross-section of the phosphorus compound-coated rare earth-iron-nitrogen-based magnetic powder prepared in Example 1. The two figures on the right side show electron diffraction (ED) diagrams of the structures within the frames indicated by the white rectangles in the figure on the left side.
FIG. 2B shows, on the left side, a TEM image of a cross-section of the phosphorus compound-coated rare earth-iron-nitrogen-based magnetic powder prepared in Example 2. The two figures on the right side show ED diagrams of the structures within the frames indicated by the white rectangles in the figure on the left side.
FIG. 3A shows the results of a line analysis of the phosphorus compound-coated rare earth-iron-nitrogen-based magnetic powder prepared in Example 1.
FIG. 3B shows the results of a line analysis of the phosphorus compound-coated rare earth-iron-nitrogen-based magnetic powder prepared in Example 2.
FIG. 3C shows the results of a line analysis of the phosphorus compound-coated rare earth-iron-nitrogen-based magnetic powder prepared in Comparative Example 1.
FIG. 4 shows the frequency dependences of the complex relative permeabilities of magnetic materials prepared in Examples 3 and 4 and Comparative Example 2.
FIG. 5 shows the frequency dependence of the complex relative permeability of a magnetic material for hyper-high frequency absorption prepared in Example 5.

### DESCRIPTION OF EMBODIMENTS

Embodiments of the present disclosure are described in detail below. The following embodiments, however, are intended as examples to give a concrete form of the technical idea of the present disclosure and are not intended to limit the scope of the present disclosure to the following embodiments. In the present specification, the term "step" encompasses not only an independent step but also a step that may not be clearly distinguished from other steps, as long as a desired object of the step is achieved. Moreover, numerical ranges indicated using "to" refer to ranges including the numerical values before and after "to" as the minimum and maximum, respectively.

Herein, the term "high frequency" refers to electromagnetic waves with high frequencies. In this disclosure, the term particularly refers to electromagnetic waves of at least 1 MHz but lower than 1 GHz, unless otherwise stated.

As used herein, the term "good efficiency" means that the ratio of the real part (µ') to the imaginary part (µ") of the complex relative permeability (µ), i.e., the Q value (quality coefficient), of the magnetic material at a given frequency f is high. Magnetic materials with such properties can be used to amplify electromagnetic waves at the given frequency f while reducing their loss. The ratio of µ" to µ' refers to the tan δ (= µ"/µ') or loss factor, and the tan δ is equal to the reciprocal of the Q value. Low tan δ and high tan δ are referred to as "good efficiency" and "poor efficiency", respectively. Moreover, lower tan δ and higher tan δ are also referred to as "improved tan δ" and "deteriorated tan δ", respectively.

In the present specification, "magnetic field amplification" characteristics refer to characteristics in which the real part (µ') of the complex relative permeability of the magnetic material is higher than the real part (= 1) of the relative permeability of vacuum, and the magnetic field in the space where the magnetic material is placed is increased compared to the magnetic field in vacuum (or in the atmosphere). Good or high magnetic field amplification characteristics mean high µ'. Materials with µ' values exceeding 2 at a given frequency f are referred to as magnetic materials "for magnetic field amplification" (at the frequency f). The term "relative permeability" when used alone is a general term for the absolute values of the real part and the imaginary part of the complex relative permeability. High relative permeability means that the real part of the relative permeability is high, unless otherwise stated.

In the present specification, the term "hyper-high frequency absorption" characteristics refers to high-frequency characteristics in a hyper-high frequency range, and means characteristics in which the imaginary part (µ") of the complex relative permeability of the magnetic material in a hyper-high frequency range is larger than 0, and high frequencies incident to the space where the magnetic material is placed are attenuated. Good or high hyper-high frequency absorption characteristics at a given frequency mean high µ" at the frequency. Materials with µ" values exceeding 0 in a hyper-high frequency range are referred to as "magnetic materials for hyper-high frequency absorption". Only for magnetic materials for hyper-high frequency absorption, higher µ" and lower µ" may also be referred to as "improved µ"" and "deteriorated µ"", respectively. Moreover, both the magnetic field amplification characteristics in a high frequency range and the high-frequency absorption characteristics in a hyper-high frequency range are collectively referred to as "high-frequency characteristics".

### Method of producing magnetic powder

A method of producing a magnetic powder according to the present embodiment includes performing a phosphorus treatment to obtain a phosphorus compound and a rare earth-iron-nitrogen-based magnetic powder, the phosphorus treatment including adding an inorganic acid to a slurry containing: a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of the total R content; water; and a phosphorus-containing substance.

### Phosphorus treatment step

In the phosphorus treatment step, an inorganic acid may be added to a slurry containing a rare earth-iron-nitrogen-based magnetic powder containing R, Fe, and N, water, and a phosphorus-containing substance to obtain a phosphorus compound and a rare earth-iron-nitrogen-based magnetic powder. The resulting phosphorus compound and rare earth-iron-nitrogen-based magnetic powder may be formed by reacting the metal component (for example, iron, neodymium, etc.) in the rare earth-iron-nitrogen-based magnetic powder with the phosphorus component (for example, phosphoric acid) in the phosphorus-containing substance to precipitate a phosphorus compound (for example, iron phosphate, neodymium phosphate, etc.). Moreover, the resulting phosphorus compound and rare earth-iron-nitrogen-based magnetic powder are preferably formed by precipitating the phosphorus compound on the surface of the rare earth-iron-nitrogen-based magnetic powder so that it coats at least a part of the surface of the rare earth-iron-nitrogen-based magnetic powder (such coating is referred to as "phosphorus compound coating", and the portion formed by such coating is referred to as "phosphorus compound coating portion"). In the present embodiment, an inorganic acid is added to adjust the pH of the slurry, which allows the amount of the precipitated phosphorus compound to be increased as compared to when no inorganic acid is added. Thus, a phosphorus compound-coated rare earth-iron-nitrogen-based magnetic powder in which the thickness of the coating portion (also referred to as film thickness) is increased can be produced, and therefore the tan δ is reduced and the magnetic field amplification characteristics are improved. Moreover, the use of water as a solvent according to the present embodiment allows the precipitated phosphorus compound such as phosphate to have a smaller particle size than that when using an organic solvent. Thus, a dense phosphorus compound and a rare earth-iron-nitrogen-based magnetic powder can be obtained, which tend to provide good efficiency in a high frequency range or good absorption characteristics in a hyper-high frequency range.

The slurry that contains a rare earth-iron-nitrogen-based magnetic powder containing R, Fe, and N, water, and a phosphorus-containing substance can be prepared by any appropriate method, such as mixing a rare earth-iron-nitrogen-based magnetic powder with a phosphorus-containing substance solution, containing a phosphorus-containing substance, using water as a solvent. The amount of the rare earth-iron-nitrogen-based magnetic powder in the slurry is preferably at least 1% by mass but not more than 50% by mass. In view of productivity, the amount is more preferably at least 5% by mass but not more than 20% by mass. Any appropriate amount of the phosphorus-containing substance can be contained in the slurry. When the phosphorus-containing substance is phosphoric acid and consists only of hydrogen and the phosphate component (PO₄), the amount of the phosphorus-containing substance, calculated as PO₄, is, for example, at least 0.01% by mass but not more than 10% by mass. In consideration of reactivity between the metal component and the phosphate component and productivity, the amount is preferably at least 0.05% by mass but not more than 5% by mass.

Examples of the phosphorus-containing substance include phosphorus alone and composites thereof; phosphate compounds such as orthophosphoric acid; heteropoly acid compounds such as phosphotungstic acid and phosphomolybdic acid; salts of phosphorus-containing acid compounds such as phosphate compounds or heteropoly acid compounds and metal ions or ammonium ions; organic phosphorus compounds such as phosphate esters, phosphite esters, and phosphine oxides; and phosphorus-containing metals such as iron phosphide, phosphor bronze, Fe-B-P-Cu based alloys, and Fe-Nb-B-P based alloys.

When the phosphorus-containing substance is a phosphate compound, an aqueous phosphate solution may be prepared by mixing the phosphate compound with water. Examples of the phosphate compound include orthophosphoric acid, sodium dihydrogen phosphate, sodium monohydrogen phosphate, ammonium dihydrogen phosphate, ammonium monohydrogen phosphate, zinc phosphate, calcium phosphate, and other phosphates, hypophosphorous acid, hypophosphites, pyrophosphoric acid, polyphosphoric acid, and other inorganic phosphoric acids, and organic phosphoric acids. These may be used alone or in combinations of two or more of these. To improve the water resistance and corrosion resistance of the coating portion and the magnetic properties of the magnetic powder, additives may also be used including, for example, oxoacid salts such as molybdates, tungstates, vanadates, and chromates; oxidizing agents such as sodium nitrate and sodium nitrite; and chelating agents such as EDTA. In consideration of reaction control and coating amount control, phosphate compounds such as inorganic phosphoric acids such as orthophosphoric acid, pyrophosphoric acid, and polyphosphoric acid, and phosphates of these inorganic phosphoric acids with Na, Ca, Pb, Zn, Fe, Y, Ce, Pr, Nd, Gd, Tb, Dy, Ho, Er, Tm, Lu, Sm, ammonium, etc., are preferred among the phosphorus-containing substances.

The phosphate concentration (calculated as PO₄) in the aqueous phosphate solution is preferably at least 5% by mass but not more than 50% by mass. In consideration of the solubility and storage stability of the phosphate compound and ease of chemical conversion treatment, the concentration is more preferably at least 10% by mass but not more than 30% by mass. The pH of the aqueous phosphate solution is preferably at least 1 but not higher than 4.5. In order to facilitate control of the precipitation rate of the phosphate, the pH is more preferably at least 1.5 but not higher than 4. The pH may be adjusted using dilute hydrochloric acid, dilute sulfuric acid, or the like.

In the phosphorus treatment step, an inorganic acid may be added to make the slurry acidic. The pH is preferably adjusted to at least 1 but not higher than 4.5, more preferably at least 1.6 but not higher than 3.9, still more preferably at least 2 but not higher than 3. If the pH is lower than 1, aggregation of the rare earth-iron-nitrogen-based magnetic powder particles tends to occur starting from the locally highly precipitated phosphorus compound, resulting in a deteriorated tan δ in a high frequency range and a lower µ" in a hyper-high frequency range. If the pH is higher than 4.5, the amount of the precipitated phosphorus compound such as phosphate tends to decrease, resulting in a deteriorated tan δ in a high frequency range and a lower µ" in a hyper-high frequency range. Examples of the inorganic acid to be added include hydrochloric acid, nitric acid, sulfuric acid, boric acid, and hydrofluoric acid. In the phosphorus treatment step, the inorganic acid is preferably added as appropriate to adjust the pH within the above-described range. Although the inorganic acid is used in consideration of liquid waste disposal, an organic acid may be used together depending on the purpose. Examples of the organic acid include acetic acid, formic acid, and tartaric acid.

The phosphorus treatment step may be performed such that the resulting magnetic powder has a phosphorus content of at least 0.02% by mass. The phosphorus content of the magnetic powder obtained in the phosphorus treatment step is preferably at least 0.05% by mass, more preferably at least 0.15% by mass. The phosphorus content of the magnetic powder obtained in the phosphorus treatment step is preferably not higher than 4% by mass, more preferably not higher than 2% by mass, still more preferably not higher than 1% by mass. A phosphorus content of at least 0.02% by mass tends to further increase the effect of the phosphorus compound coating. A phosphorus content of not higher than 4% by mass tends to hinder an increase in tan δ in a high frequency range and a decrease in µ" in a hyper-high frequency range due to aggregation of the rare earth-iron-nitrogen-based magnetic powder particles starting from the phosphorus compound. Particularly, in order to prepare a magnetic material for magnetic field amplification having good efficiency or a magnetic material for hyper-high frequency absorption having good absorption characteristics, the phosphorus content is preferably at least 0.15% by mass but not higher than 1% by mass. Here, the bulk phosphorus content of the total magnetic powder can be measured by ICP atomic emission spectroscopy (ICP-AES). Moreover, the local phosphorus contents of the magnetic powder phase and the phosphorus compound coating portion of the phosphorus compound-coated powder can be measured by energy-dispersive X-ray spectroscopy (STEM-EDX). Moreover, the atomic concentration of phosphorus (P) in the phosphorus compound coating portion is preferably at least 1 atm%, more preferably at least 5 atm%. The atomic concentration of P in the phosphorus compound coating portion may also be not more than 25 atm%, preferably not more than 15 atm%. If the phosphorus content in the phosphorus compound coating portion is less than 1 atm%, the phosphorus compound tends to be less likely to serve as an electrical insulation. If the phosphorus content is more than 25 atm%, not only the real part of the relative permeability in a high frequency range and the imaginary part of the relative permeability in a hyper-high frequency range tend to decrease, but also the corrosion resistance performance tends to decrease.

The phosphorus treatment step may be performed such that the phosphorus compound coating portion on the surface of the resulting magnetic powder has a region (R-rich region) with a higher atomic concentration of the rare earth R than the atomic concentration of R in the rare earth (R)-iron-nitrogen-based magnetic powder, which is a base material. The atomic concentration of R in the R-rich region may be at least 1.05 times, preferably at least 1.1 times, more preferably at least 1.2 times, still more preferably at least 1.5 times the atomic concentration of R in the rare earth-iron-nitrogen-based magnetic powder. The atomic concentration of R in the R-rich region may also be, for example, not more than 4 times the atomic concentration of R in the rare earth-iron-nitrogen-based magnetic powder. The R-rich region is a region including a layer that shows a phosphorus (P) peak in a STEM-EDX line analysis of the phosphorus compound-coated rare earth-iron-nitrogen-based magnetic powder. For example, the thickness of the R-rich region may be at least 1 nm, preferably at least 3 nm but not more than 150 nm, more preferably at least 10 nm but not more than 100 nm, still more preferably at least 20 nm but not more than 80 nm. The atomic concentration (atm%) of each element in the R-rich region can be determined by averaging the atomic concentrations in the phosphorus compound coating portion measured in a STEM-EDX line analysis. The rare earth element R may be Nd, for example. In this case, the atomic concentration of Nd in the Nd-rich region may be a reference for evaluation.

The adjustment of the pH of the slurry containing the rare earth-iron-nitrogen-based magnetic powder, water, and the phosphorus-containing substance to be at least 1 but not higher than 4.5 is preferably performed for at least 10 minutes. To reduce the thin parts of the coating portion, the adjustment is more preferably performed for at least 30 minutes. In the pH maintenance, as the pH initially increases rapidly, the inorganic acid for pH control needs to be introduced at short intervals. Then, as the coating proceeds, pH fluctuations gradually decrease, which allows the inorganic acid to be introduced at longer intervals. This allows for determining the end point of the reaction.

### Oxidation step after phosphorus treatment

The magnetic powder obtained in the phosphorus treatment step may optionally be subjected to an oxidation treatment. When the magnetic powder is subjected to an oxidation treatment, the surface of the rare earth-iron-nitrogen-based magnetic powder may be oxidized to form an iron oxide layer, which improves the oxidation resistance of the magnetic powder. Moreover, the oxidation can inhibit undesirable oxidation-reduction reaction, decomposition reaction, and alteration from occurring on the particle surface of the rare earth-iron-nitrogen-based magnetic powder when the magnetic powder is exposed to high temperatures. As a result, a magnetic material having magnetic field amplification characteristics with a low tan δ in a high frequency range as well as absorption characteristics with a high µ" in a hyper-high frequency range can be obtained.

The oxidation treatment may be performed by heat-treating the phosphorus-treated magnetic powder in an oxygen-containing atmosphere. The reaction atmosphere preferably contains oxygen in an inert gas such as nitrogen or argon. The oxygen concentration is preferably at least 3% but not more than 21%, more preferably at least 3.5% but not more than 10%. During the oxidation reaction, gas exchange is preferably performed at a flow rate of at least 2 L/min but not higher than 10 L/min per 1 kg of the magnetic powder.

The temperature during the oxidation treatment is preferably at least 150 °C but not higher than 330 °C, more preferably at least 150 °C but not higher than 250 °C, still more preferably at least 170 °C but not higher than 230 °C. At a temperature of lower than 150 °C, an iron oxide layer tends to be insufficiently formed, resulting in lower oxidation resistance. At a temperature of higher than 330 °C, an iron oxide layer tends to be excessively formed, reducing the real part of the relative permeability in a high frequency range and the imaginary part of the relative permeability in a hyper-high frequency range. The reaction time is preferably at least 3 hours but not longer than 10 hours.

### Silica treatment step

The phosphorus-treated magnetic powder may optionally be subjected to a silica treatment. Forming a silica thin film on the magnetic powder can improve oxidation resistance. The silica thin film may be formed, for example, by mixing an alkyl silicate, the magnetic powder, and an alkali solution.

### Silane coupling treatment step

The silica-treated magnetic powder may be further treated with a silane coupling agent. When the magnetic powder provided with a silica thin film is subjected to a silane coupling treatment, a silane coupling agent film may be formed on the silica thin film, which improves the magnetic properties of the magnetic powder as well as wettability between the magnetic powder and the resin and the strength of the molded product. Any appropriate silane coupling agent may be used and may be selected depending on the resin type. Examples of the silane coupling agent include 3-aminopropyltriethoxysilane, γ-(2-aminoethyl)aminopropyltrimethoxysilane, γ-(2-aminoethyl)aminopropylmethyldimethoxysilane, γ-methacryloxypropyltrimethoxysilane, γ-methacryloxypropylmethyldimethoxysilane, N-β-(N-vinylbenzylaminoethyl)-γ-aminopropyltrimethoxysilane hydrochloride, γ-glycidoxypropyltrimethoxysilane, γ-mercaptopropyltrimethoxysilane, methyltrimethoxysilane, methyltriethoxysilane, vinyltriacetoxysilane, γ-chloropropyltrimethoxysilane, hexamethylenedisilazane, γ-anilinopropyltrimethoxysilane, vinyltrimethoxysilane, octadecyl[3-(trimethoxysilyl)propyl]ammonium chloride, γ-chloropropylmethyldimethoxysilane, γ-mercaptopropylmethyldimethoxysilane, methyltrichlorosilane, dimethyldichlorosilane, trimethylchlorosilane, vinyltrichlorosilane, vinyltris(β-methoxyethoxy)silane, vinyltriethoxysilane, β-(3,4-epoxycyclohexyl)ethyltrimethoxysilane, γ-glycidoxypropylmethyldiethoxysilane, N-β-(aminoethyl)-γ-aminopropyltrimethoxysilane, N-β-(aminoethyl)-γ-aminopropylmethyldimethoxysilane, γ-aminopropyltriethoxysilane, N-phenyl-γ-aminopropyltrimethoxysilane, ureidopropyltriethoxysilane, γ-isocyanatopropyltriethoxysilane, polyethoxydimethylsiloxane, polyethoxymethylsiloxane, bis(trimethoxysilylpropyl)amine, bis(3-triethoxysilylpropyl)tetrasulfane, γ-isocyanatopropyltrimethoxysilane, vinylmethyldimethoxysilane, 1,3,5-N-tris(3-trimethoxysilylpropyl)isocyanurate, t-butyl carbamate trialkoxysilane, and N-(1,3-dimethylbutylidene)-3-(triethoxysilyl)-1-propaneamine. These silane coupling agents may be used alone or in combinations of two or more of these. The amount of the silane coupling agent added per 100 parts by mass of the magnetic powder is preferably at least 0.2 parts by mass but not more than 0.8 parts by mass, more preferably at least 0.25 parts by mass but not more than 0.6 parts by mass. If the amount is less than 0.2 parts by mass, the effect of the silane coupling agent tends to be small. If the amount is more than 0.8 parts by mass, the magnetic properties of the magnetic powder or molded product tend to decrease due to aggregation of the magnetic powder.

The magnetic powder obtained after the phosphorus treatment step, oxidation step, silica treatment step, or silane coupling treatment step may be filtered, dehydrated, and dried in a typical manner.

The rare earth-iron-nitrogen-based magnetic powder used in the production method according to the present embodiment contains R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of the total R content. R is at least one selected from the group consisting of Y, Ce, Pr, Nd, Gd, Tb, Dy, Ho, Er, Tm, Lu, and Sm, preferably from Nd, Y, Ce, Pr, Gd, and Dy in view of stability of raw material supply and high relative permeability, more preferably from Nd, Y, Ce, and Pr in view of cost. The amount of Sm, if present, is less than 50 atm%, preferably less than 20 atm% of the total R content. In particular, when the amount of Nd or Pr is at least 50 atm% of the total R content, a magnetic material with a higher relative permeability or a lower tan δ can be obtained. Further, in view of the balance between oxidation resistance and cost, the amount of Nd or Pr is preferably at least 70 atm%. The rare earth-iron-nitrogen-based magnetic powder particularly preferably includes NdFeN in which the amount of Nd is 100 atm% because of the high abundance of resources, the large absolute value of magnetocrystalline anisotropy field (index showing the level of magnetic anisotropy), and the high absorption ability at further hyper-high frequencies.

The amount of Fe in the rare earth-iron-nitrogen-based magnetic powder is preferably at least 40 atm% but not more than 87 atm%, more preferably at least 50 atm% but not more than 85 atm%.

The rare earth-iron-nitrogen-based magnetic powder used in the production method according to the present embodiment may be a nitride having a Th₂Zn₁₇-type crystal structure and containing R, iron (Fe), and nitrogen (N), where R represents at least one selected from the group consisting of Y, Ce, Pr, Nd, Gd, Tb, Dy, Ho, Er, Tm, Lu, and Sm, and if R contains Sm, Sm constitutes less than 50 atm% of the total R content, as represented by the general formula: RₓFe_{100-x-y}N_{y}, preferably wherein x is at least 3 but not more than 30; y is at least 10 but not more than 30; and the balance is mainly Fe.

The silica treatment step and/or silane coupling treatment step may be replaced or followed by subjecting the magnetic powder to a surface treatment with a coupling agent, examples of which include titanium coupling agents such as isopropyl triisostearoyl titanate, isopropyl tri(N-aminoethyl-aminoethyl)titanate, isopropyl tris(dioctylpyrophosphate)titanate, tetraisopropyl bis(dioctylphosphite)titanate, tetraisopropyl titanate, tetrabutyl titanate, tetraoctyl bis(ditridecylphosphite)titanate, isopropyl trioctanoyl titanate, isopropyl tridodecylbenzenesulfonyl titanate, isopropyl tri(dioctylphosphate)titanate, bis(dioctylpyrophosphate)ethylenetitanate, isopropyl dimethacryl isostearoyl titanate, tetra(2,2-diallyloxymethyl-1-butyl)bis(ditridecylphosphite)titanate, and isopropyl tricumyl phenyl titanate, aluminum-based coupling agents such as acetoalkoxyaluminum diisopropylate, zirconium-based coupling agents, chromium-based coupling agents, iron-based coupling agents, and tin-based coupling agents. When the powder obtained through this treatment is used as a bonded magnetic material, the affinity with the resin added may be improved, the isolation and dispersion of the phosphorus compound-coated rare earth-iron-nitrogen-based magnetic powder may become more significant, and electrical insulation between the powder particles may be provided, resulting in good efficiency in a high frequency range or good absorption characteristics in a hyper-high frequency range.

The rare earth-iron-nitrogen-based magnetic powder can be produced by any appropriate method. Exemplary such methods are described in detail below.

### Solid phase method

A method of producing a rare earth-iron-nitrogen-based magnetic powder using a solid phase method includes:
mixing a R oxide powder, a Fe raw material, and a Ca powder (mixing step);
reducing the resulting mixture (reduction step); and
nitriding alloy particles obtained in the reduction step (nitridation step).

### Mixing step

The Fe raw material in the mixing step may include not only metallic Fe but also Fe₂O₃ and/or Fe₃O₄. The amount of Fe₂O₃ and/or Fe₃O₄, if used (the total number of moles of Fe in Fe₂O₃ and/or Fe₃O₄ relative to the total number of moles of Fe in metallic Fe and Fe₂O₃ and/or Fe₃O₄) is preferably not more than 30 atm%.
The reaction heat generated when the iron oxides are reduced by Ca may allow the overall reaction to uniformly proceed, which allows for saving the external energy and enhancing the yield. The amount of granular Ca mixed needs to be enough to reduce the R oxide and the selectively mixed metal oxide(s). The amount of granular Ca may be at least 0.5 times but not more than three times, preferably at least one time but not more than two times the equivalent amount of oxygen atoms in the R oxide and selectively mixed Fe₂O₃ and/or Fe₃O₄.

### Reduction step

The powder mixture obtained in the mixing step may be placed in a heating vessel which can be vacuum-evacuated. After vacuum evacuation of the heating vessel, the powder mixture may be heated at a temperature of at least 600 °C but not higher than 1300 °C, preferably at least 700 °C but not higher than 1200 °C, more preferably at least 800 °C but not higher than 1100 °C while passing argon gas therethrough. If the heating temperature is lower than 600 °C, the reduction reaction of the oxide may not proceed. If the heating temperature is higher than 1300 °C, the rare earth and Fe may melt into bulk form. Moreover, when the heating temperature is at least 700 °C, the reduction time tends to be shortened, resulting in improved productivity. When the heating temperature is not higher than 1200 °C, scattering of Ca tends to be reduced, resulting in further reduced variations during the reduction. To more uniformly perform the reduction reaction, the heat treatment time may be equal to or shorter than four hours, preferably shorter than 120 minutes, more preferably shorter than 90 minutes. The heat treatment time is preferably at least 10 minutes, more preferably at least 30 minutes. When the powder mixture contains an appropriate amount of Fe₂O₃ and/or Fe₃O₄ in addition to metallic Fe, they can self-heat during the temperature rise, so that a uniform reaction can proceed efficiently. However, if metallic Fe is mixed with Fe₂O₃ and/or Fe₃O₄ in an amount exceeding 30 atm%, calculated as elementary Fe, as described in the mixing step, explosion or scattering may occur due to extremely high heat generation. Moreover, the particle size of the resulting rare earth-iron-nitrogen-based magnetic powder can be controlled by controlling the reduction temperature. Generally, the higher the reduction temperature, the larger the powder particle size.

### Nitridation step

Cooling may be performed in argon gas to a temperature range of preferably at least 250 °C but not higher than 800 °C, more preferably at least 300 °C but not higher than 600 °C. To increase the reaction efficiency by reducing decomposition of the nitridation reaction product in the later stage of the nitridation step, the temperature is still more preferably lowered to a temperature range of at least 400 °C but not higher than 550 °C. Subsequently, the heating vessel may be again vacuum-evacuated and then nitrogen gas may be introduced thereinto. The gas to be introduced is not limited to nitrogen and may be nitrogen atom-containing gas such as ammonia. The contents may be heated for at least four hours, preferably for at least 10 hours but not longer than 40 hours, while passing nitrogen gas therethrough at atmospheric pressure or higher, followed by stopping the heating and standing to cool.

The product obtained after the nitridation step may contain, in addition to the rare earth-iron-nitrogen-based magnetic powder, materials such as by-product CaO and unreacted metallic calcium, which may be combined into sintered bulk form. In this case, a water washing step may be performed in which the product may be introduced into ion exchange water to separate calcium oxide (CaO) and other calcium-containing components as a calcium hydroxide (Ca(OH)₂) suspension from the magnetic particles. In the water washing step, stirring in water, leaving still, and supernatant removal may be repeated several times. Further, the residual calcium hydroxide may be sufficiently removed by washing the magnetic particles with acetic acid or the like.

The water washing step is preferably performed after the heat treatment in a nitrogen atmosphere because the residual unreacted Ca can be converted to calcium nitride (CaN), which can be more easily removed. The rare earth-iron-nitrogen-based magnetic powder obtained as above tends to have a sharper particle size distribution.

### Precipitation method

A method of producing a rare earth-iron-nitrogen-based magnetic powder using a precipitation method includes:
mixing a solution containing R and Fe with a precipitant to obtain a precipitate containing R and Fe (precipitation step);
firing the precipitate to obtain an oxide containing R and Fe (oxidation step);
heat-treating the oxide in a reducing gas-containing atmosphere to obtain a partial oxide (pretreatment step);
reducing the partial oxide (reduction step); and
nitriding alloy particles obtained in the reduction step (nitridation step).

### Precipitation step

In the precipitation step, a R raw material and a Fe raw material may be dissolved in a strong acid solution to prepare a solution containing R and Fe. Any appropriate R or Fe raw material which can be dissolved in a strong acid solution may be used. In view of availability, examples of the R raw material include R oxides, and examples of the Fe raw material include iron sulfate (FeSO₄). The concentration of the solution containing R and Fe may be appropriately adjusted within a range in which the R raw material and the Fe raw material can be substantially dissolved in the acid solution. In view of solubility, the acid solution may include sulfuric acid.

The solution containing R and Fe may be reacted with a precipitant to obtain an insoluble precipitate containing R and Fe. The solution containing R and Fe can be any solution that contains R and Fe at the time of the reaction with a precipitant. For example, separate solutions containing a R raw material and a Fe raw material, respectively, may be prepared and individually added dropwise to be reacted with a precipitant. When the separate solutions are prepared, the solutions may also be appropriately adjusted within a range in which the respective raw materials can be substantially dissolved in the acid solution. The precipitant may be any alkaline solution that can react with the solution containing R and Fe to give a precipitate. Examples include ammonia water and caustic soda, with caustic soda being preferred.

After separating the precipitate, the separated precipitate is preferably subjected to solvent removal in order to reduce aggregation of the precipitate caused by evaporation of the residual solvent in which the precipitate has been re-dissolved during the heat treatment in the subsequent oxidation step, and to reduce changes in properties such as particle size distribution and powder particle size. Specifically, when the solvent used is water, for example, the solvent removal may be performed by drying in an oven at a temperature of at least 70 °C but not higher than 200 °C for at least 5 hours but not longer than 12 hours.

The precipitation step may be followed by washing and separating the resulting precipitate. The washing process may be appropriately performed until the conductivity of the supernatant solution reaches 5 mS/m or lower. The precipitate separation process may be performed, for example, by mixing the resulting precipitate with a solvent (preferably water), followed by filtration, decantation, or other separation methods.

### Oxidation step

The oxidation step includes firing the precipitate formed in the precipitation step to obtain an oxide containing R and Fe. For example, the precipitate may be converted into an oxide by heat treatment. The heat treatment of the precipitate needs to be performed in the presence of oxygen, for example in an air atmosphere. Moreover, because the presence of oxygen is necessary, the non-metal portions of the precipitate preferably contain oxygen atoms. The heat treatment can be performed at any appropriate heat treatment temperature (hereinafter, oxidation temperature) in the oxidation step, but the heat treatment temperature is preferably at least 700 °C but not higher than 1300 °C, more preferably at least 900 °C but not higher than 1200 °C. If the oxidation temperature is lower than 700 °C, the oxidation tends to be insufficient. If the oxidation temperature is higher than 1300 °C, the resulting rare earth-iron-nitrogen-based magnetic powder tends not to have the target shape, average particle size, and particle size distribution. The heat treatment can be performed for any appropriate heat treatment time, and the heat treatment time may be at least 0.5 hours but not longer than 4 hours, preferably at least 1 hour but not longer than 3 hours.

### Pretreatment step

The pretreatment step includes heat-treating the oxide containing R and Fe in a reducing gas-containing atmosphere to obtain a partial oxide, which is a partially reduced product of the oxide.

### Reduction step

The reduction step includes heating the partial oxide in the presence of a reducing agent at a temperature of at least 600 °C but not higher than 1300 °C, preferably at least 700 °C but not higher than 1200 °C, more preferably at least 800 °C but not higher than 1100 °C. If the heating temperature is lower than 600 °C, the reduction reaction of the oxide may not proceed. If the heating temperature is higher than 1300 °C, R and Fe may melt into bulk form. Moreover, when the heating temperature is at least 700 °C, the reduction time tends to be shortened, resulting in improved productivity. When the heating temperature is not higher than 1200 °C, scattering of the reducing agent Ca tends to be reduced, resulting in further reduced variations during the reduction. The particle size of the rare earth-iron-nitrogen-based magnetic powder can be controlled by controlling the reduction temperature. Generally, the higher the reduction temperature, the larger the powder particle size. To more uniformly perform the reduction reaction, the heat treatment time is preferably shorter than 120 minutes, more preferably shorter than 90 minutes. The heat treatment time is preferably at least 10 minutes, more preferably at least 30 minutes.

### Nitridation step

The nitridation step includes nitriding the alloy particles obtained in the reduction step to obtain anisotropic magnetic particles. As the particulate precipitate obtained in the precipitation step described above is used, the alloy particles obtained in the reduction step are in porous bulk form. This allows the alloy particles to be directly nitrided by heat treatment in a nitrogen atmosphere without grinding, resulting in uniform nitridation.

The heat treatment temperature in the nitridation of the alloy particles (hereinafter, nitridation temperature) is preferably at least 250 °C but not higher than 800 °C, more preferably at least 300 °C but not higher than 600 °C. Moreover, in order to increase the reaction efficiency by reducing decomposition of the nitridation reaction product in the later stage of the nitridation step, the nitridation is particularly preferably performed within a temperature range of at least 400 °C but not higher than 550 °C in an atmosphere substituted with nitrogen. The heat treatment time may be selected such that the alloy particles can be sufficiently uniformly nitrided. For example, they may be heated for at least four hours, suitably for at least 10 hours but not longer than 40 hours, while passing nitrogen gas therethrough at atmospheric pressure or higher, followed by stopping the heating and standing to cool.

The product obtained after the nitridation step may contain, in addition to the rare earth-iron-nitrogen-based magnetic powder, materials such as by-product CaO and unreacted metallic calcium, which may be combined into sintered bulk form. In this case, a water washing step may be performed in which the product may be introduced into ion exchange water to separate calcium oxide (CaO) and other calcium-containing components as a calcium hydroxide (Ca(OH)₂) suspension from the magnetic particles. In the water washing step, stirring in water, leaving still, and supernatant removal may be repeated several times. Further, the residual calcium hydroxide may be sufficiently removed by washing the magnetic particles with acetic acid or the like. The water washing step is preferably performed after the heat treatment in a nitrogen atmosphere because the residual unreacted Ca can be converted to calcium nitride (CaN), which can be more easily removed. The rare earth-iron-nitrogen-based magnetic powder obtained as above tends to have a sharper particle size distribution.

### Phosphorus compound-coated rare earth-iron-nitrogen-based magnetic powder

A magnetic powder according to the present embodiment contains a phosphorus compound and R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of the total R content. The rare earth-iron-nitrogen-based magnetic powder and the phosphorus content according to the present embodiment are as described above in the phosphorus treatment step. The rare earth-iron-nitrogen-based magnetic powder is a nitride and therefore has a higher electrical resistivity than metal materials and also has high corrosion resistance.

The average particle size of the phosphorus compound-coated rare earth-iron-nitrogen-based magnetic powder is preferably at least 0.1 µm but not more than 100 pm. For a magnetic material for magnetic field amplification, it is preferably at least 1 µm but not more than 100 µm. For a magnetic material for hyper-high frequency absorption, it is preferably at least 0.1 µm but not more than 10 um. A more preferred particle size range is 3 µm to 100 µm for a later-described magnetic material for magnetic field amplification, or is 0.1 µm to 3 µm for a magnetic material for hyper-high frequency absorption. If the average particle size is less than 1 pm, the amount of the magnetic powder filled in the molded product may be reduced, so that the real part of the relative permeability in a high frequency range or the imaginary part of the relative permeability in a hyper-high frequency range may decrease. If the average particle size is not more than 0.1 µm, the specific surface area is further increased, and thus the volume fraction of a magnetic portion having a high real part of the relative permeability in a high frequency range or a high imaginary part of the relative permeability in a hyper-high frequency range may decrease. Consequently, the magnetic material properties tend to be extremely lowered. If the average particle size is more than 10 µm, the µ" of the molded product tends to decrease. This tendency is more significant when the average particle size is more than 100 µm. As used herein, the average particle size refers to the median diameter measured under a dry condition using a laser diffraction particle size distribution analyzer. Specifically, the average particle size of the magnetic powder herein is defined as D50, which refers to the particle size corresponding to 50% of the cumulative particle size distribution based on volume of the phosphorus compound-coated rare earth-iron-nitrogen-based magnetic powder.

As the particle size of the rare earth-iron-nitrogen-based magnetic powder increases, eddy currents may start to occur in the particles at a low frequency due to the skin effect. Thus, with a larger particle size, the real part of the relative permeability may start to decrease in a lower frequency range. Therefore, the magnetic powder having a small particle size tends to maintain high magnetic field amplification characteristics or hyper-high frequency absorption characteristics even at high frequencies. In the case of Nd₂Fe₁₇N₃, for example, the relationship between the particle size r (m) of the magnetic powder and the frequency f₀ (Hz) at which the real part of the relative permeability starts to decrease is presumably f₀ = 1 THz with r = 0.1 um, f₀ = 1 GHz with r = 3 µm, and f₀ = 1 MHz with r = 100 µm. Therefore, the rare earth-iron-nitrogen-based magnetic powder having a particle size with an upper limit around the above range is preferred as a magnetic field amplification material according to the present disclosure. Moreover, a smaller particle size cannot gain the filling ratio of the molded product and also increases the surface area. For example, if the phosphorus compound coating portion has a thickness of 10 nm, the relative permeability can be reduced only by about 50% when the particle size of the powder is 0.1 um, but the relative permeability can be about 6% when the particle size is 0.05 um. Thus, the lower limit of the powder particle size of the magnetic powder according to the present disclosure should be around 0.1 um, regardless of the frequency. In consideration of the above-described tradeoff, the particle size is preferably adjusted to a range that is more suitable for the target frequency range of the magnetic material.

The DSC exothermic onset temperature of the phosphorus compound-coated rare earth-iron-nitrogen-based magnetic powder is preferably at least 145 °C, more preferably at least 170 °C. The DSC exothermic onset temperature represents an overall evaluation of the properties of the phosphorus compound, including density, thickness, and oxidation resistance. Good efficiency in a high frequency range and good hyper-high frequency absorption characteristics in a hyper-high frequency range can be obtained when the DSC exothermic onset temperature is at least 145 °C. The DSC exothermic onset temperature can be measured under the conditions described in Examples.

The phosphorus compound-coated rare earth-iron-nitrogen-based magnetic powder preferably has a carbon content of not higher than 1000 ppm by mass, more preferably not higher than 800 ppm by mass, still more preferably not higher than 500 ppm by mass, particularly preferably not higher than 420 ppm by mass. The carbon content indicates the amount of organic impurities in the phosphorus compound. If the carbon content exceeds 1000 ppm by mass, voids may be formed in the phosphorus compound by decomposition of organic impurities when the magnetic powder is exposed to high temperature. Thus, the efficiency tends to decrease, and therefore the magnetic field amplification characteristics in a high frequency range or the hyper-high frequency absorption characteristics tend to decrease. In particular, in order to achieve good efficiency in a high frequency range and good hyper-high frequency absorption characteristics in a hyper-high frequency range, the carbon content is preferably at least 0 ppm by mass but not higher than 800 ppm by mass. Here, the carbon content can be measured by a TOC method.

When the surface of the rare earth-iron-nitrogen-based magnetic powder is coated with the phosphorus compound, the thickness of the coating portion is preferably at least 10 nm but not more than 200 nm, more preferably at least 12 nm but not more than 100 nm, to improve the tan δ of the magnetic material in a high frequency range or the µ" in a hyper-high frequency range. The thickness of the coating portion can be measured by a composition analysis on a cross-section of the phosphorus compound-coated rare earth-iron-nitrogen-based magnetic powder. The composition analysis can be performed by conducting a line or area analysis on a transmission electron microscopic (TEM) image, STEM image, or FE-SEM image by energy dispersive X-ray analysis (EDX), or a point analysis with sufficient measurement points. In the measurement in a line analysis, etc., for example, a region where the observed atomic concentration of phosphorus (P) is at least 1 atm% may be regarded as the phosphorus compound coating portion. Typical examples of ideal powder microstructures with good high-frequency characteristics according to the present embodiment include a structure in which the phosphorus compound coating portion covers the entire surface (surface coverage 100%) of the rare earth-iron-nitrogen-based magnetic powder. In this case, electrical insulation between the adjacent magnetic particles has been found to be completely maintained. In other words, this structure can exhibit the effect of reducing iron loss due to inter-particle eddy currents by the phosphorus compound coating portion and can further improve the tan δ in a high frequency range to provide a more efficient magnetic material for magnetic field amplification. It can also reduce the eddy current influence in a frequency range even in a hyper-high frequency range to provide a magnetic material for hyper-high frequency absorption that maintains higher hyper-high frequency absorption characteristics. Here, the phosphorus compound coating portion may not completely cover the surface of the rare earth-iron-nitrogen-based magnetic powder, and a surface coverage of at least 10% is expected to exhibit the eddy current reducing effect to some degree. The desired surface coverage is preferably at least 50%, more preferably at least 80%. At a surface coverage of at least 10% but less than 80%, a free phosphorus compound is preferably present between the particles of the magnetic powder. The surface coverage with the phosphorus compound coating portion of the magnetic powder can be estimated by observing a cross-section of the powder using TEM, STEM, or FE-SEM equipped with EDX. The ratio of the length of the contact portion of the phosphorus-containing coat to the entire circumferential length of the surface portion of the rare earth-iron-nitrogen-based magnetic powder observed is defined as "surface coverage". Preferably, cross-sections of 20 to 50 particles of the magnetic powder in an image observed as described above may be measured and averaged, and the average value may be taken as the surface coverage.

The phosphorus compound coating portion on the surface of the rare earth-iron-nitrogen-based magnetic powder may have a region (R-rich region) with a higher atomic concentration of the rare earth R than the atomic concentration of R in the base material rare earth-iron-nitrogen-based magnetic powder. The atomic concentration of R in the R-rich region may be at least 1.05 times, preferably at least 1.1 times, more preferably at least 1.2 times, still more preferably at least 1.5 times the atomic concentration of R in the rare earth-iron-nitrogen-based magnetic powder. The atomic concentration of R in the R-rich region may also be, for example, not more than 4 times the atomic concentration of R in the rare earth-iron-nitrogen-based magnetic powder. The R-rich region is a region including a layer that exhibits the maximum phosphorus (P) peak in a STEM-EDX line analysis of the phosphorus compound-coated rare earth-iron-nitrogen-based magnetic powder. For example, the thickness of the R-rich region may be at least 1 nm, preferably at least 3 nm but not more than 150 nm, more preferably at least 10 nm but not more than 100 nm, still more preferably at least 20 nm but not more than 80 nm. When the atomic concentration of R in the R-rich region relative to the atomic concentration of R in the base material is within the above range, the electrical resistivity tends to be increased to provide a high relative permeability. The atomic concentration (atm%) of each element in the R-rich region can be determined by averaging the atomic concentrations in the phosphorus compound coating portion measured in a STEM-EDX line analysis. The rare earth element may be Nd, for example. In this case, the atomic concentration of Nd in the Nd-rich region may be used as a reference for evaluation.

The atomic concentration of R in the R-rich region may be at least 0.3 times, preferably at least 1 time the atomic concentration of Fe in the R-rich region. The atomic concentration of R in the R-rich region is preferably not more than 20 times the atomic concentration of Fe in the R-rich region. When the relationship between the atomic concentration of R and the atomic concentration of Fe in the R-rich region is within the above range, the atomic concentration of Fe near the surface of the rare earth-iron-nitrogen-based magnetic powder tends to decrease, further improving water resistance.

The ratio of the atomic concentration of R to the atomic concentration of Fe (R/Fe) in the R-rich region may be at least 0.3, preferably at least 0.5, more preferably at least 1, still more preferably at least 2. The R/Fe ratio in the R-rich region may be not higher than 100 or not higher than 10. The R/Fe ratio in the R-rich region may also be higher than the R/Fe ratio in the base material rare earth-iron-nitrogen-based magnetic powder. The R/Fe ratio in the R-rich region may be at least 1 time, preferably at least 1.5 times, more preferably at least 2 times, still more preferably at least 5 times the R/Fe ratio in the base material rare earth-iron-nitrogen-based magnetic powder. When the R/Fe ratio in the R-rich region is within the above range, the atomic concentration of Fe near the surface of the rare earth-iron-nitrogen-based magnetic powder tends to decrease, further improving water resistance.

The rare earth-iron-nitrogen-based magnetic powder is a nitride having a Th₂Zn₁₇-type or Th₂Ni₁₇-type crystal structure and containing R, iron (Fe), and nitrogen (N), where R represents at least one selected from the group consisting of Y, Ce, Pr, Nd, Gd, Tb, Dy, Ho, Er, Tm, Lu, and Sm, and if R contains Sm, Sm constitutes less than 50 atm% of the total R content, as represented by the general formula: RₓFe_{100-x-y}N_{y}. It is preferable that x is at least 3 but not more than 30; y is at least 10 but not more than 30; and the balance is mainly Fe. This magnetic powder is a ferromagnetic powder.

Examples of the phosphorus compound contained in the phosphorus compound-coated rare earth-iron-nitrogen-based magnetic powder include phosphate compounds such as inorganic phosphoric acids such as orthophosphoric acid, pyrophosphoric acid, and polyphosphoric acid, and phosphates of these inorganic phosphoric acids with Na, Ca, Pb, Zn, Fe, R, ammonium, etc. (herein, these metal elements or atomic groups are referred to as M components and may also be denoted simply as M); and "phosphorus-containing amorphous compounds" and "phosphorus-containing nanocrystalline compounds" which contain at least one selected from R, Fe, M, and N, and P and/or a phosphorus-containing substance. Among these, phosphates, "phosphorus-containing amorphous compounds", and "phosphorus-containing nanocrystalline compounds" are preferred, in consideration of, e.g., forming a dense surface coating on the rare earth-iron-nitrogen-based magnetic powder. The presence of a "phosphorus-containing nanocrystalline compound" provides better thermal stability, so that the high-frequency characteristics of the magnetic powder after the phosphorus treatment tend to less easily deteriorate, even when the magnetic powder undergoes a kneading step or heat-curing step in which high heat is applied. Further, this can contribute to high thermal stability of the resulting molded product. As used herein, the term "nanocrystalline" means a fine crystal of at least 1 nm but less than 1 µm. Phosphorus compounds containing fine crystals of less than 1 nm are considered as being within the scope of amorphous compounds. The crystallinity of the phosphorus compound coating portion and the diameter of the fine crystals in the phosphorus compound coating portion can be determined by lattice image observation using a TEM method or by analysis using an electron diffraction (ED) device attached to a TEM device. The amount of the phosphorus compound in the phosphorus compound-coated rare earth-iron-nitrogen-based magnetic powder is preferably at least 0.5% by mass but not more than 4.5% by mass, more preferably at least 0.55% by mass but not more than 2.5% by mass, most preferably at least 0.75% by mass but not more than 2% by mass. If the amount is more than 4.5% by mass, the rare earth-iron-nitrogen-based magnetic powder tends to aggregate, resulting in a lower relative permeability, and at the same time, the tan δ in a high frequency range tends to deteriorate. If the amount is less than 0.5% by mass, the electrically insulating effect of the phosphorus compound coating portion tends to decrease, similarly resulting in a lower relative permeability, and the tan δ in a high frequency range tends to deteriorate. Moreover, the phosphorus content of the phosphorus compound-coated rare earth-iron-nitrogen-based magnetic powder may be at least 0.02% by mass. The phosphorus content of the phosphorus compound-coated rare earth-iron-nitrogen-based magnetic powder is preferably at least 0.05% by mass, more preferably at least 0.15% by mass. The phosphorus content of the phosphorus compound-coated rare earth-iron-nitrogen-based magnetic powder is preferably not higher than 4% by mass, more preferably not higher than 2% by mass, still more preferably not higher than 1% by mass.

The phosphorus compound preferably covers at least a part of the surface of the rare earth-iron-nitrogen-based magnetic powder in order not to cause an efficiency reduction due to eddy currents, i.e., an increase in tan δ. In the magnetic powder, a surface coverage of at least 10% can exhibit the eddy current reducing effect to some degree. The desired surface coverage is preferably at least 50%, more preferably at least 80%. A surface coverage of lower than 10% is not preferable because it cannot sufficiently block inter-particle eddy currents, resulting in a higher than δ. The rare earth-iron-nitrogen-based magnetic powder with 100% coverage with the phosphorus compound coating portion can provide an extremely low tan δ and may achieve a tan δ of not higher than 0.01 at 1 MHz, depending on the composition, crystal structure, powder particle size, etc. of the magnetic powder.

The phosphorus compound preferably covers at least a part of the surface of the rare earth-iron-nitrogen-based magnetic powder in order not to cause a reduction in relative permeability, particularly µ", due to eddy currents, i.e., a deterioration of hyper-high frequency absorption characteristics. A surface coverage of at least 10% can exhibit the eddy current reducing effect to some degree. The desired surface coverage is preferably at least 50%, more preferably at least 80%. A surface coverage of lower than 10% is not preferable because it cannot sufficiently block inter-particle eddy currents, leading to reduction of the µ" due to the skin effect. The rare earth-iron-nitrogen-based magnetic powder with 100% coverage with the phosphorus compound coating portion can show an extremely small reduction in relative permeability due to eddy currents and may achieve a µ" of at least 1 at 1 GHz, depending on the composition, crystal structure, powder particle size, etc. of the magnetic powder.

A surface coverage of at least 10% can exhibit the eddy current reducing effect to some degree. The desired surface coverage is preferably at least 50%, more preferably at least 80%. A surface coverage of lower than 10% in a high frequency range of less than 1 GHz tends not to sufficiently block inter-particle eddy currents, resulting in a higher tan δ. The rare earth-iron-nitrogen-based magnetic powder with 100% coverage with the phosphorus compound coating portion can provide an extremely low tan δ and may achieve a tan δ of not higher than 0.01 at 1 MHz, depending on the composition, crystal structure, powder particle size, etc. of the magnetic powder.

Moreover, the rare earth-iron-nitrogen-based magnetic powder according to the present embodiment has planar magnetocrystalline anisotropy in which the magnetic moment tends to be directed to the c-plane direction rather than the c-axis direction. For the magnetic powder according to the present embodiment, maintaining a high real part µ' of the relative permeability in a high frequency range and exhibiting a high imaginary part µ" of the relative permeability in a hyper-high frequency range greatly depend on having this feature. The magnetic powder according to the present embodiment has a very large absolute value of the negative magnetocrystalline anisotropy energy, and such a magnetic powder having planar magnetocrystalline anisotropy is present without orientation. Therefore, the natural resonance frequency is widely distributed within a range of 1 GHz to 1 THz. Thus, an increase in µ" and a decrease in µ' due to natural resonance may not occur at lower than 1 GHz, while a high µ" due to natural resonance may occur in a broad frequency band of at least 1 GHz but not higher than 1 THz. Particularly in the magnetic powder according to the present embodiment, the surface of the ferromagnetic powder is coated with the phosphorus compound in the magnetic powder, and the phosphorus compound is present between the particles of the magnetic powder. Therefore, the generation of inter-particle eddy currents can be reduced. Moreover, when the magnetic powder has a predetermined average particle size, the generation of intra-particle eddy currents can also be reduced. Therefore, the inherent high-frequency characteristics of the magnetic powder tend to be further improved in a frequency range of 1 MHz to 1 THz as the deterioration due to eddy currents can be reduced. There is no known "magnetic field amplification material" created according to a material design idea that fully covers such a broad frequency band. There is also no known "hyper-high frequency absorbing material" which can function seamlessly in a "very broad frequency band" according to the same design concept.

### Magnetic material for magnetic field amplification

A magnetic material for magnetic field amplification according to the present embodiment is characterized by including a phosphorus compound and a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of the total R content.

The magnetic material for magnetic field amplification according to the present embodiment including the rare earth-iron-nitrogen-based magnetic powder and the phosphorus compound can have a high relative permeability with a µ' of at least 2 in a frequency range of at least 1 MHz but lower than 1 GHz for magnetic field amplification and may also have good efficiency with a tan δ of not more than 0.2 in a frequency range of at least 1 MHz but lower than 1 GHz. As the magnetic material for magnetic field amplification according to the present embodiment, any appropriate material can be used as long as it includes a phosphorus compound and a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of the total R content. For example, the magnetic powder according to the embodiments described above may be used.

The rare earth-iron-nitrogen-based magnetic powder preferably has a particle size of at least 1 µm but not more than 100 µm. The reason for this is that, as described above, if a powder larger than 100 µm is used in a magnetic material for magnetic field amplification at 1 MHz or higher, the relative permeability tends to be reduced due to the skin effect. Further, when a powder of at least 7 um is utilized in a magnetic material for magnetic field amplification, a high pressure of at least 0.5 GPa is applied to increase the volume fraction, which may cause the particles of the powder to come into contact with each other and cause a large eddy current loss, leading to great reduction of the real part of the relative permeability. Therefore, in order to also avoid deterioration of the inherent properties such as relative permeability of a magnetic powder, it is very important that a fine and moderately soft substance such as a phosphorus compound, which is not as hard as ferrite or oxides of transition metals and not as soft as resins, covers a rare earth-iron-nitrogen-based magnetic powder or be present between particles. In other words, the inclusion of a phosphorus compound is required for the method of producing a magnetic material for magnetic field amplification according to the present embodiment in which a large pressure is applied to achieve a high density and a high relative permeability and for the magnetic material for magnetic field amplification produced by the method.

The magnetic material for magnetic field amplification can be preferably used at a frequency of at least 1 MHz but lower than 1 GHz. At a frequency of at least 1 GHz, it is also usable as a magnetic material for hyper-high frequency absorption. Therefore, depending on the composition, particle size distribution, etc. of the rare earth-iron-nitrogen-based magnetic powder, the imaginary part of the relative permeability may start to increase in a frequency range of at least 0.5 GHz but lower than 1 GHz. The magnetic material for magnetic field amplification according to the present embodiment may be used in a frequency range of at least 1 MHz but lower than 0.5 GHz, preferably of at least 1 MHz but lower than 0.1 GHz. The use of the magnetic material as a material for magnetic field amplification in the above frequency range is preferred in terms of the balance between cost and properties because a powder of at least 3 µm but not more than 100 µm can be used without using a fine grinding machine such as a jet mill and also because it is not necessary to perform magnetic field orientation or other process which can reduce the throughput.

Examples of more specific applications of the magnetic material for magnetic field amplification include wireless power transfer coils, magnetic field amplification materials for radio frequency identification (RFID) tags, and transformers, inductors, and reactors of circuits for high frequencies higher than 20 MHz. For example, the magnetic material may be used as a magnetic material for magnetic field amplification as follows: the magnetic material may be prepared in the form of a thin sheet and attached to the back of an antenna or a receiver/transmitter to concentrate the magnetic flux in the sheet by its magnetic field amplification characteristics; alternatively, the magnetic material may be inserted into the inside of a cylindrical coil or rectangular parallelepiped coil, or a conducting wire may be wound around a donut-shaped magnetic core or a magnetic core with a yoke to improve the real part of the relative permeability of the coil.

The magnetic material for magnetic field amplification according to the present embodiment has a high real part of the relative permeability even in a high frequency range. For example, the real part of the relative permeability at a frequency of at least 1 MHz but not higher than 20 MHz is preferably at least 3, more preferably at least 4. Moreover, the real part of the relative permeability at a frequency of higher than 20 MHz but lower than 1 GHz is preferably at least 2, more preferably at least 3. Moreover, for example, the magnetic material for magnetic field amplification according to the present embodiment may have a real part µ' of the relative permeability at a frequency of 20 MHz of at least 3.2, preferably at least 3.5, more preferably at least 4, still more preferably at least 4.5. The magnetic material for magnetic field amplification according to the present embodiment may have a real part µ' of the relative permeability at a frequency of 20 MHz of not more than 200 or not more than 100, for example.

The magnetic material for magnetic field amplification according to the present embodiment preferably has a Q value (µ'/µ") at 20 MHz of at least 3, more preferably at least 3.5, still more preferably at least 4. The Q value at 20 MHz may also be not more than 10000. With a Q value at 20 MHz within the above range, the magnetic material may preferably serve as a magnetic field amplification material having good efficiency and low cost, particularly when it is used around this frequency (for example, at least 10 MHz but not higher than 30 MHz). When the Q value is at least 3, the heat generated in an element or system into which the magnetic material is incorporated can be reduced to reduce the temperature of the components, etc. Thus, the stability tends to be improved. When the Q value is not more than 10000, the cost required to increase the material homogeneity can be reduced. The complex relative permeability can be determined by measuring the impedance of a toroidal sample using an impedance analyzer, a (vector) network analyzer, or a BH analyzer, and then converting the result to the complex relative permeability, or by using the S parameter method, depending on the frequency range (for example, when measured using a network analyzer at a frequency of at least 500 MHz).

The magnetic material for magnetic field amplification according to the present embodiment also has a relative permeability with low frequency dependence. For example, in a wireless power transfer application where the power is supplied at a frequency of 13.56 MHz, a magnetic material whose real part µ' of the relative permeability varies only slightly in a frequency range including this frequency of at least 2 MHz but not higher than 20 MHz exhibits good efficiency and is thus preferred. Moreover, since many materials have a relative permeability that varies greatly even at 5 MHz or lower, the material having a stable real part of the relative permeability in a frequency range of at least 2 MHz but not higher than 20 MHz is also preferred for applications in this frequency range, etc. In these applications, materials whose µ' varies greatly in the above frequency range also tend to have a correspondingly large deviation of µ" from 0, resulting in deteriorated tan δ. The ratio of the real part of the relative permeability at 20 MHz to the real part of the relative permeability at 2 MHz is preferably at least 0.8, more preferably at least 0.9. The ratio of the real part of the relative permeability at 20 MHz to the real part of the relative permeability at 2 MHz may also be not higher than 1.1. When the ratio of the real parts of the relative permeabilities is at least 0.8, a decrease in energy efficiency tends to be reduced, so that the heat generated in a device into which the magnetic material is incorporated can be reduced. Moreover, when the ratio of the real parts of the relative permeabilities is not higher than 1.1, the input to and output from the device tend to be easily controllable.

The magnetic material for magnetic field amplification according to the present embodiment may include a resin. The composite material of the magnetic material and the resin is referred to as a bonded magnetic material. The resin in the bonded magnetic material may be a thermosetting resin or a thermoplastic resin. Examples of the thermoplastic resin include polyphenylene sulfides (PPS), polyether ether ketones (PEEK), liquid crystal polymers (LCP), polyamides (PA), polypropylenes (PP), polyethylenes (PE), and thermoplastic elastomers. Examples of the thermosetting resin include epoxy resins, phenol resins, urea resins, melamine resins, guanamine resins, unsaturated polyester resins, vinyl ester resins, diallyl phthalate resins, polyurethane resins, silicone resins, polyimide resins, alkyd resins, furan resins, dicyclopentadiene resins, acrylic resins, allyl carbonate resins, and thermosetting elastomers commonly called rubbers.

The amount of the resin in the bonded magnetic material is preferably at least 0.1% by mass but not more than 95% by mass. When the amount of the resin component is at least 0.1% by mass, impact resistance can be further improved. When the amount is not more than 95% by mass, a drastic decrease in relative permeability or magnetization can be reduced. Further, in applications of the bonded magnetic material according to the present embodiment which require high relative permeability as well as impact resistance, the amount is more preferably in the range of 0.5% by mass to 50% by mass for the reason described above. In applications such as a high frequency circuit transformer with particularly good efficiency, the amount is most preferably in the range of 1% by mass but to 15% by mass. To provide a magnetic material for magnetic field amplification according to the present embodiment with a particularly high real part of the relative permeability or a hyper-high frequency absorbing material with particularly good absorption characteristics, the amount is also preferably not more than 15% by mass, though it may vary more or less depending on the application. A non-sinter-hardened molded product containing no resin, for example, a compact which is prepared with an auxiliary agent such as a volatile organic solvent, is very fragile and thus is very difficult to apply to, for example, a magnetic field amplification material such as a wireless power transfer coil or an inductor magnetic coil, to which a load will be applied, or a hyper-high frequency absorbing material mounted on a 5G+ or 6G mobile device which is frequently carried and often subjected to impact. Moreover, a molded product containing many penetrating air spaces, such as a compact pressed at a pressure of not higher than 1.5 GPa, tends to be unsuitable for applications at high temperatures because it may be oxidized and degraded or become extremely fragile when exposed to a temperature of at least 50 °C for a long time, resulting in deteriorated impact resistance. Thus, the amount of the resin in the molded product for these applications is preferably at least 0.1% by mass but not more than 95% by mass, more preferably at least 0.5% by mass but not more than 50% by mass, still more preferably at least 1% by mass but not more than 15% by mass.

The resin compound for the bonded magnetic material may be prepared, for example, by mixing and/or kneading the phosphorus compound, the rare earth-iron-nitrogen-based magnetic powder, and the resin using a kneading machine at a temperature of at least 180 °C but not higher than 300 °C, or mixing and/or kneading the phosphorus compound-coated rare earth-iron-nitrogen-based magnetic powder and the resin using a kneading machine at a temperature of at least 180 °C but not higher than 300 °C. For example, the phosphorus compound-coated rare earth-iron-nitrogen-based magnetic powder and the resin may be mixed using a mixer and then kneaded and extruded using a twin-screw extruder into a strand, which may then be cooled in the air and cut into a size of several millimeters using a pelletizer, which allows for obtaining pellets of the resin compound for the bonded magnetic material according to the present embodiment.

The resin compound may be molded using an appropriate molding machine, which allows for producing the bonded magnetic material according to the present embodiment. Specifically, for example, the resin compound may be melted in the barrel of a molding machine and then injection-molded in a mold to which a magnetic field is applied to align the easy axes of magnetization (orientation step), which allows for obtaining a magnetic field orientation-molded bonded magnetic material. Moreover, a bonded magnetic material sheet for magnetic field amplification or a bonded magnetic material sheet for hyper-high frequency absorption may be prepared by calendering or hot-pressing the pellets of the resin compound. The sheet may be rolled to a thickness of at least 20 µm but not more than 200 µm to produce a magnetic material for magnetic field amplification having a high real part of the relative permeability, which may be preferably used as, for example, a molded magnetic material sheet for magnetic field amplification for RFID tags and may be used as a molded magnetic material sheet for hyper-high frequency absorption for mobile devices.

### Magnetic material for hyper-high frequency absorption

A magnetic material for hyper-high frequency absorption according to the present embodiment includes a phosphorus compound and a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of the total R content.

The magnetic material for hyper-high frequency absorption according to the present embodiment including the rare earth-iron-nitrogen-based magnetic powder and the phosphorus compound can have a high imaginary part of the relative permeability with a µ" of at least 0.2 in a frequency range of 1 GHz to 0.11 THz and may also serve as a magnetic material for magnetic field amplification with a µ" of at least 0.1 over most of the frequency range of at least 1 MHz but lower than 1 GHz. As the magnetic material for hyper-high frequency absorption according to the present embodiment, any appropriate material may be used as long as it includes a phosphorus compound and a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of the total R content. For example, the magnetic powder according to the embodiments described above may be used.

The rare earth-iron-nitrogen-based magnetic powder used in the magnetic material for hyper-high frequency absorption preferably has an average particle size of at least 0.1 um but not more than 10 um. The reason for this is as described above, and the relative permeability of a powder of at least 3 µm tends to be reduced in a hyper-high frequency range of at least 1 GHz due to the skin effect, and therefore the powder particle size should be at least 0.1 µm, if possible. Also, direct contact between the magnetic particles should be avoided as much as possible. For example, if a rare earth-iron-nitrogen-based magnetic powder of 30 µm is ground to a size of not more than 5 um to be used as a hyper-high frequency magnetic material, the particles of the magnetic powder may come into contact with each other to be electrically connected during molding, and the electrically connected aggregates may have an average size of 30 µm. In this case, the effect of the particle size on high-frequency characteristics can be equal to that obtained when the unground powder is used, thus losing the purpose of grinding. Particularly, in the preparation of a magnetic sheet, which often uses a molding method such as hot pressing or calendering in which heat and pressure are simultaneously applied, it is preferred that an insulating film such as a phosphorus compound be firmly adhered to the magnetic particle surface so that the magnetic particles are electrically insulated from each other even when the magnetic particles aggregate in the molded product matrix. A high frequency magnetic material having a high density and a high relative permeability can be produced by coating the surface of a magnetic powder, which easily aggregates, with a fine and moderately soft phosphorus compound, which is not as hard as ferrite or oxides of transition metals, and applying heat and pressure simultaneously.

The magnetic material for hyper-high frequency absorption according to the present embodiment has a high imaginary part µ" of the relative permeability even at hyper-high frequencies. For example, the imaginary part µ" of the relative permeability at a frequency of at least 1 GHz but lower than 20 GHz is preferably at least 0.2, more preferably at least 0.3. Moreover, the imaginary part µ" of the relative permeability at a frequency of at least 20 GHz but not higher than 1 THz is preferably at least 0.1, more preferably at least 0.2. Moreover, for example, the magnetic material for hyper-high frequency absorption according to the present embodiment may have an imaginary part µ" of the relative permeability at a frequency of 10 GHz that is at least 0.2, preferably at least 0.47, more preferably at least 0.5, still more preferably at least 0.55. The magnetic material for hyper-high frequency absorption according to the present embodiment may have an imaginary part µ" of the relative permeability at a frequency of 10 GHz that is not more than 5 or not more than 4. Moreover, for example, the magnetic material for hyper-high frequency absorption according to the present embodiment may have an imaginary part µ" of the relative permeability at a frequency of 0.11 THz that is at least 0.02, preferably at least 0.05, more preferably at least 0.1, still more preferably at least 0.2. The magnetic material for hyper-high frequency absorption according to the present embodiment may have an imaginary part µ" of the relative permeability at a frequency of 0.11 THz that is not more than 2 or not more than 1.5. Furthermore, for example, the magnetic material for hyper-high frequency absorption according to the present embodiment preferably has a ratio of the imaginary part µ" of the relative permeability at a frequency of 0.11 THz to the imaginary part µ" of the relative permeability at a frequency of 10 GHz that is at least 0.03, more preferably at least 0.1. The magnetic material for hyper-high frequency absorption according to the present embodiment preferably has a ratio of the imaginary part µ" of the relative permeability at a frequency of 0.11 THz to the imaginary part µ" of the relative permeability at a frequency of 10 GHz that is not higher than 5, more preferably not higher than 1. When the magnetic material for hyper-high frequency absorption has a ratio of the imaginary part µ" of the relative permeability at a frequency of 0.11 THz to the imaginary part µ" of the relative permeability at a frequency of 10 GHz within the above range, it can exhibit higher absorption characteristics in a broad frequency band.

The magnetic material for hyper-high frequency absorption according to the present embodiment including the rare earth-iron-nitrogen-based magnetic powder and the phosphorus compound can absorb hyper-high frequencies in a very broad frequency range of 1 GHz to 1 THz, and is distinct from magnetic materials which have a low relative permeability in a narrow frequency bandwidth of about 10 GHz, such as uniaxial magnetocrystalline anisotropic materials (e.g., hexagonal ferrite, boride, and epsilon iron oxide) which are expected to be used at such hyper-high frequencies. The presence of a phosphorus compound with high electrical resistivity in a magnetic powder is a key feature for planar magnetocrystalline anisotropic materials which have a lower electrical resistivity than oxide materials but have a higher resistance than metal materials and maintain the high-frequency characteristics at up to 1 THz.

Examples of more specific applications of the magnetic material for hyper-high frequency absorption include mobile communication equipment, mobile phone small base stations, and cloud base stations for 5th generation mobile communication systems (5G), 5th generation plus mobile communication systems (5G+), and 6th generation mobile communication systems (6G); components for absorbing hyper-high frequency signals and spurious signals for their infrastructure equipment such as apparatuses, devices, and antennas; components for absorbing hyper-high frequency signals and spurious signals for apparatuses and devices used in intelligent transport systems (ITS), wireless high-definition multimedia interface (HDMI) (registered trademark), wireless local area network (LAN), satellite broadcasting (Ka-band), etc.; and electromagnetic noise absorbing components for removing mainly the second to seventh harmonics in personal computers.

The magnetic material for hyper-high frequency absorption according to the present embodiment may contain a resin. The composite material of the magnetic material and the resin is referred to as a bonded magnetic material. The resin in the bonded magnetic material may be a thermosetting resin or a thermoplastic resin. Examples of the thermoplastic resin include polyphenylene sulfides (PPS), polyether ether ketones (PEEK), liquid crystal polymers (LCP), polyamides (PA), polypropylenes (PP), polyethylenes (PE), and thermoplastic elastomers. Examples of the thermosetting resin include epoxy resins, phenol resins, urea resins, melamine resins, guanamine resins, unsaturated polyester resins, vinyl ester resins, diallyl phthalate resins, polyurethane resins, silicone resins, polyimide resins, alkyd resins, furan resins, dicyclopentadiene resins, acrylic resins, allyl carbonate resins, and thermosetting elastomers commonly called rubbers.

The amount of the resin in the bonded magnetic material is preferably at least 0.1% by mass but not more than 95% by mass. When the amount of the resin component is at least 0.1% by mass, impact resistance can be further improved. When the amount is not more than 95% by mass, a drastic reduction in relative permeability or magnetization can be reduced. Further, in applications of the bonded magnetic material according to the present embodiment which require high relative permeability as well as impact resistance, the amount is more preferably at least 0.5% by mass but not more than 50% by mass for the reason described above. In applications such as a high frequency circuit transformer with particularly good efficiency, the amount is further preferably at least 1% by mass but not more than 15% by mass. To provide a magnetic material for magnetic field amplification according to the present embodiment with a particularly high real part of the relative permeability or a hyper-high frequency absorbing material with particularly good absorption characteristics, the amount is also preferably not more than 15% by mass, though it may vary more or less depending on the application. A non-sinter-hardened molded product containing no resin, for example, a compact which is prepared with an auxiliary agent such as a volatile organic solvent, is very fragile and thus is very difficult to apply to, for example, a magnetic field amplification material such as a wireless power transfer coil or an inductor magnetic coil, to which a load will be applied, or a hyper-high frequency absorbing material mounted on a 5G+ or 6G mobile device which is frequently carried and often subjected to impact. Moreover, a molded product containing many penetrating air spaces, such as a compact pressed at a pressure of not higher than 1.5 GPa, tends to be unsuitable for applications at high temperatures because it may be oxidized and degraded or become very fragile when exposed to a temperature of at least 50 °C for a long time, resulting in deteriorated impact resistance. Thus, the amount of the resin in the molded product for these applications is preferably at least 0.1% by mass but not more than 95% by mass, more preferably at least 0.5% by mass but not more than 50% by mass, still more preferably at least 1% by mass but not more than 15% by mass.

The resin compound for the bonded magnetic material may be prepared, for example, by mixing and/or kneading the phosphorus compound, the rare earth-iron-nitrogen-based magnetic powder, and the resin, or the phosphorus compound-coated rare earth-iron-nitrogen-based magnetic powder and the resin using a kneading machine at a temperature of at least 180 °C but not higher than 300 °C. For example, the phosphorus compound-coated rare earth-iron-nitrogen-based magnetic powder and the resin may be mixed using a mixer and then kneaded and extruded using a twin-screw extruder into a strand, which may then be cooled in the air and cut into a size of several millimeters using a pelletizer, which allows for obtaining pellets of the resin compound for the bonded magnetic material according to the present embodiment.

The resin compound may be molded using an appropriate molding machine, whereby the bonded magnetic material according to the present embodiment can be produced. Specifically, for example, the resin compound may be melted in the barrel of a molding machine and then injection-molded in a mold to which a magnetic field is applied to align the easy axes of magnetization (orientation step), allowing for obtaining a magnetic field orientation-molded bonded magnetic material. Moreover, a bonded magnetic material sheet for magnetic field amplification or a bonded magnetic material sheet for hyper-high frequency absorption may be prepared by calendering or hot pressing the pellets of the resin compound. The sheet may be rolled to a thickness of at least 20 um but not more than 200 um to produce a magnetic material for magnetic field amplification having a high real part of the relative permeability, which may be preferably used as, for example, a molded magnetic material sheet for magnetic field amplification for RFID tags and may be used as a molded magnetic material sheet for hyper-high frequency absorption for mobile devices.

### EXAMPLES

The present disclosure is further specifically described with reference to, but not limited to, the following examples and other embodiments.

The evaluation methods performed in the examples are as described below.

### 1) DSC exothermic onset temperature

The exothermic onset temperature was measured by weighing 20 mg of the phosphorus compound-coated magnetic powder and subjecting it to DSC analysis using a high-temperature differential scanning calorimeter (DSC6300, Hitachi High-Tech Science Corporation) under measurement conditions including an air atmosphere (200 mL/min), a temperature rise from room temperature to 400 °C (rate of temperature rise: 20 °C/min), and alumina (20 mg) as reference. A higher exothermic onset temperature indicates less heat generated by oxidation, meaning that a denser phosphorus compound coating is formed.

### 2) P content

The P content in the phosphorus compound-coated magnetic powder was measured by ICP atomic emission spectroscopy (ICP-AES).

### 3) Total carbon content (TC)

The total carbon (TC) content in the phosphorus compound-coated magnetic powder was measured using a combustion catalytic oxidation-type total organic carbon (TOC) analyzer (Shimadzu Corporation, model: SSM-5000A).

### 4) Thickness, atomic concentrations, and crystallinity of phosphorus compound coating portion

The thickness and atomic concentrations of the phosphorus compound coating portion on the surface of the phosphorus compound-coated magnetic powder were measured as follows. First, the prepared magnetic powder was dispersed in an epoxy resin and solidified and then cross-sectioned using a focused ion beam (FIB) to obtain a cross-sectional sample for measurement. The respective values of the sample were estimated using STEM (FEI, model No. Talos F200X, acceleration voltage: 200 kV) and STEM-EDX (system: FEI, model No. SuperX, detector: SDD detector, Bruker) attached to the STEM. To determine the atomic concentrations in the phosphorus compound coating portion, a line analysis was performed in steps of 0.184 nm from the exterior to the interior of the phosphorus compound-coated magnetic powder to observe continuous changes in the atomic concentrations of the structural elements, thereby determining a region where the atomic concentration of phosphorus (P) was at least 1 atm%. At this time, because a lot of carbon (C) from the resin used to prepare the cross-sectional sample might be detected in some measurement points, the atomic concentrations were calculated based on the total elements, excluding C. Moreover, the crystallinity of the phosphorus compound coating portion on the surface of the phosphorus compound-coated magnetic powder was determined using TEM-ED. If no lattice fringes were visible in the TEM image, and the ED image shows a halo pattern, such a portion was determined to be an amorphous phase. The size of the phosphorus-containing nanocrystalline compound was roughly determined from the extent of the lattice fringes in the TEM image and the relationship between the size of the ED observation area and the ring pattern.

### 5) Measurement of complex relative permeability at 1 MHz to 1 GHz

The phosphorus compound-coated magnetic powder was mixed with an epoxy resin (thermosetting resin) and then kneaded to prepare a resin compound. The resin compound was charged into a mold having an inner diameter of 3.1 mm and an outer diameter of 8 mm, molded at an applied pressure of 0.8 GPa, and then heat-cured in vacuum at 150 °C for two hours to prepare a toroidal molded product. Using an impedance analyzer (HP4291B, Hewlett-Packard Company), the complex relative permeability of this sample in a frequency range of 1 MHz to 1 GHz was evaluated from the inductance determined using a single-turn inductor-type test fixture.

### 6) Measurement of complex relative permeability at 1 MHz to 0.11 THz

The phosphorus compound-coated magnetic powder was mixed and kneaded with a polyamide ester ether elastomer (thermoplastic resin) at 180 °C to prepare a resin compound. The resin compound was hot-pressed at 190 °C and an applied pressure of 12.7 MPa to prepare a 100 mm × 100 mm × 1 mm magnetic sheet. A test piece with an inner diameter of 3.1 mm and an outer diameter of 8 mm was cut out of the magnetic sheet to prepare a toroidal molded product. This sample was used to evaluate the complex relative permeability at 1 MHz to 1 GHz as in the above 5).

Further, a test piece with an inner diameter of 3.04 mm and an outer diameter of 7 mm, which was different in size from the above toroidal molded product, was cut out of the above magnetic sheet to prepare another toroidal molded product. Using a network analyzer (N5290A, Keysight Technologies), the complex relative permeability of this sample in a frequency range of 1 GHz to 18 GHz was evaluated from the S-parameters determined by the coaxial method. Further, using the network analyzer, the complex relative permeability of the 100 mm × 100 mm × 1 mm magnetic sheet prepared as above in a frequency range of 18 GHz to 0.11 THz was evaluated from the S-parameters determined by the free-space method.

### Comparative Example 1

A non-phosphorus-treated Nd₂Fe₁₇N₃ magnetic powder having an average particle size of 9 µm was prepared from iron sulfate and neodymium sulfate as raw materials by a precipitation method as described below.

### Preparation of Nd-Fe sulfuric acid solution

An amount of 5.0 kg of FeSO₄·7H₂O was mixed and dissolved in 2.0 kg of pure water. Then, 0.45 kg of Nd₂O₃ and 0.70 kg of 70% sulfuric acid were added and stirred well until they were completely dissolved. Next, pure water was added to the resulting solution so that the final Fe and Nd concentrations were adjusted to 0.726 mol/L and 0.106 mol/L, respectively, to give a Nd-Fe sulfuric acid solution.

### Precipitation step

The entire amount of the prepared Nd-Fe sulfuric acid solution was added dropwise with stirring to 20 kg of pure water, of which the temperature was maintained 40 °C, over 70 minutes from the start of the reaction, while 15% ammonia water was added dropwise to adjust the pH to 7 to 8. Thus, a slurry containing a Nd-Fe hydroxide was obtained. The slurry was washed with pure water by decantation, followed by solid-liquid separation to separate the hydroxide. The separated hydroxide was dried in an oven at 100 °C for 10 hours.

### Oxidation step

The hydroxide obtained in the precipitation step was fired in the atmosphere at 1000 °C for one hour. After cooling, a red Nd-Fe oxide was obtained as a raw material powder.

### Pretreatment step

An amount of 100 g of the Nd-Fe oxide was put in a steel vessel to a thickness of 10 mm. The vessel was placed in a furnace, and the pressure was reduced to 100 Pa. Then, while introducing hydrogen gas, the temperature was increased to a pretreatment temperature of 850 °C and maintained at this temperature for 15 hours to obtain a partial oxide as a black powder.

### Reduction step

An amount of 60 g of the partial oxide obtained in the pretreatment step was mixed with 19.2 g of metallic calcium having an average particle size of about 6 mm, and the mixture was placed in a furnace. After vacuum evacuation of the furnace, argon gas (Ar gas) was introduced. The temperature was increased to 1045 °C and maintained for 45 minutes to obtain Fe-Nd alloy particles.

### Nitridation step

Subsequently, the temperature inside the furnace was lowered to 100 °C, followed by vacuum evacuation. Then, while introducing nitrogen gas, the temperature was increased to 450 °C and maintained at this temperature for 29 hours to obtain a magnetic particle-containing bulk product.

### Water washing step

The bulk product obtained in the nitridation step was introduced into 3 kg of pure water and stirred for 30 minutes. After leaving it still, the supernatant was drained by decantation. The introduction into pure water, stirring, and decantation were repeated 10 times. Then, 2.5 g of 99.9% acetic acid was introduced and stirred for 15 minutes. After leaving it still, the supernatant was drained by decantation. The introduction into pure water, stirring, and decantation were repeated twice, followed by dehydration, drying, and then mechanical crushing to obtain a Nd₂Fe₁₇N₃ magnetic powder (average particle size: 9 pm).

### Example 1

The Nd₂Fe₁₇N₃ magnetic powder prepared in Comparative Example 1 was subjected to phosphorus treatment as follows.

A phosphate treatment liquid was prepared by mixing 85% orthophosphoric acid, sodium dihydrogen phosphate, and sodium molybdate dihydrate at a mass ratio of 1:6:1, and adding pure water and dilute hydrochloric acid to adjust the pH and the PO₄ concentration to 2 and 20% by mass, respectively. The Nd-Fe-N-based magnetic powder obtained in the water washing step was stirred in dilute hydrochloric acid (water:hydrogen chloride = 1000 g:70 g) for one minute to remove the oxidized surface film and contaminants, followed by repeating draining and supplying water until the supernatant had a conductivity of not higher than 100 pS/cm. Thus, a slurry containing 10% by mass of the Nd-Fe-N-based anisotropic magnetic powder was obtained. Then, while stirring the slurry, 100 g of the prepared phosphate treatment liquid was entirely introduced into the treatment tank. Subsequently, 6% by mass hydrochloric acid was introduced as needed to control the pH of the phosphate treatment reaction slurry within a range of 2.0 ± 0.1, which was maintained for 30 minutes. Then, the slurry was subjected to suction filtration, dehydration, and vacuum drying to obtain a phosphorus compound-coated Nd-Fe-N-based anisotropic magnetic powder.

### Example 2

The Nd₂Fe₁₇N₃ magnetic powder prepared in Comparative Example 1 was subjected to phosphorus treatment as follows.

A phosphate treatment liquid was prepared by mixing 85% orthophosphoric acid, sodium dihydrogen phosphate, and sodium molybdate dihydrate at a mass ratio of 1:6:1, and adding pure water and dilute hydrochloric acid to adjust the pH and the PO₄ concentration to 2.5 and 20% by mass, respectively. The Nd-Fe-N-based magnetic powder obtained in the water washing step was stirred in dilute hydrochloric acid (water:hydrogen chloride = 1000 g:70 g) for one minute to remove the oxidized surface film and contaminants, followed by repeating draining and supplying water until the supernatant had a conductivity of not higher than 100 µS/cm. Thus, a slurry was obtained. Then, while stirring the slurry, 100 g of the prepared phosphate treatment liquid was introduced into the treatment tank. The pH in the treatment tank rose from 2 to 6 over five minutes. The resulting slurry was stirred for 15 minutes and then subjected to suction filtration, dehydration, and vacuum drying to obtain a phosphorus compound-coated Nd-FeN-based anisotropic magnetic powder.

The DSC exothermic onset temperatures, the P contents, and the total carbon contents (TC) of the magnetic powders prepared in Examples 1 and 2 and Comparative Example 1 were measured as described above. Table 1 shows the measurement results as well as the conditions of the phosphorus treatment.

**Table 1**

| Example number | Conditions of phosphorus treatment | | Physical properties of magnetic powder | | |
|---|---|---|---|---|---|
| | Medium for treatment | pH adjustment | DSC exothermic onset temperature | P content | TC |
| | | | (°C) | (% by mass) | (ppm) |
| Example 1 | Water | pH 2 | 187 | 0.36 | 400 |
| Example 2 | Water | None | 149 | 0.068 | 250 |
| Comparative Example 1 | - | - | 141 | < 0.002 | 450 |

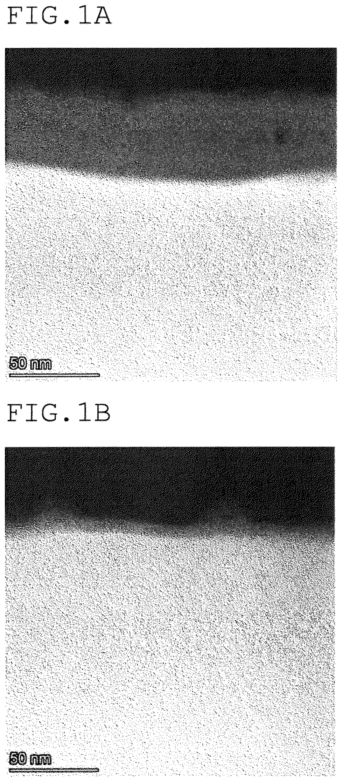

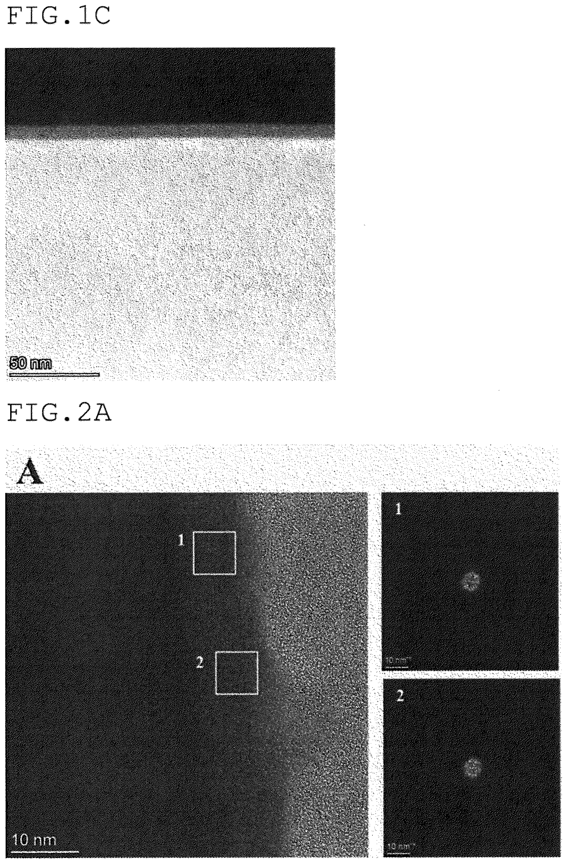

The surface and vicinity of the phosphorus-treated powder of Example 1 and those of the non-phosphorus-treated powder of Comparative Example 1 were observed with STEM-EDX. The obtained STEM images are shown in FIG. 1A and FIG. 1C, respectively. In FIG. 1A, the gray part corresponds to the phosphorus compound coating portion, the white part corresponds to the base material rare earth-iron-nitrogen-based magnetic powder, and the black part corresponds to a part outside the magnetic powder. Also, in FIG. 1C, the gray part corresponds to an oxygen-rich film (containing substantially no phosphorus), the white part corresponds to the base material rare earth-iron-nitrogen-based magnetic powder, and the black part corresponds to a part outside the magnetic powder. The film thickness of the phosphorus compound coating portion of the magnetic powder of Example 1 was about 60 nm. The atomic concentration (atm%) of P in this phosphorus compound coating portion was about 12 atm% on average. FIG. 2A shows a TEM image and ED diagrams of the magnetic powder of Example 1. The parts included in the white rectangles are considered to correspond to the phosphorus compound coating portion, the crystalline phase to the left of them is considered to correspond to the rare earth-iron-nitrogen-based magnetic powder portion, and the right part is considered to correspond to a part outside the magnetic powder (a part of the carbon layer added to provide the electrical connection necessary for measurement in the preparation of the TEM sample). The phosphorus compound coating portion of this magnetic powder included "a phosphorus-containing nanocrystalline compound" with a particle size of 1 to 5 nm and "a phosphorus-containing amorphous compound". In contrast, on the surface of the magnetic powder of Comparative Example 1, an oxygen-rich film of 5 to 10 nm was present as shown in FIG. 1C, but almost no phosphorus was detected also in the line analysis described later, and no phosphorus compound coating portion was observed.

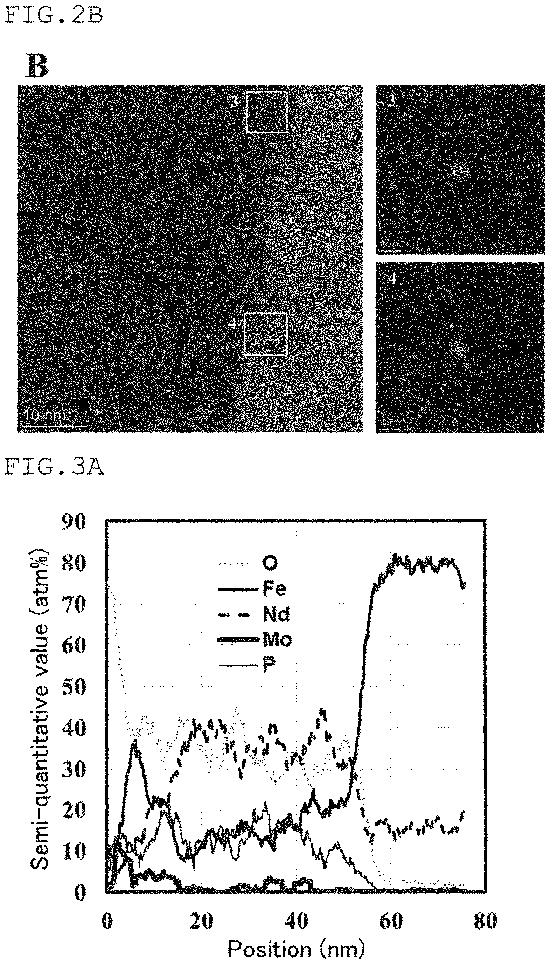

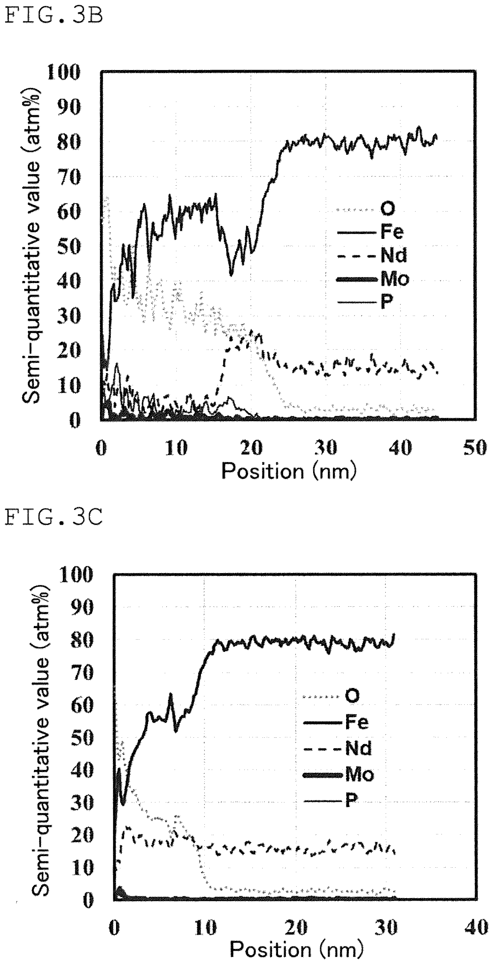

FIG. 3A and FIG. 3C show the results of STEM-EDX line analysis of the magnetic powders of Example 1 and Comparative Example 1, respectively. In FIG. 3A, a region extending about 40 nm in which the atomic concentration ratio of Nd was higher than that of Fe and the atomic concentration of Nd was higher than that in the base material magnetic powder was observed in the phosphorus compound coating portion. The average of the atomic concentration ratio of Nd to Fe (Nd/Fe) in the region was about 2.2, which was about 11 times the average of the Nd/Fe ratio of the base material rare earth-iron-nitrogen-based magnetic powder.

The results of STEM-EDX observation of the surface and vicinity of the magnetic powder of Example 2 are shown in FIG. 1B. The film thickness of the phosphorus compound coating portion of the magnetic powder was found to be about 20 nm. FIG. 2B shows a TEM image and ED diagrams of the magnetic powder. The phosphorus compound coating portion of the magnetic powder included "a phosphorus-containing nanocrystalline compound" with a particle size of 1 to 5 nm and "a phosphorus-containing amorphous compound". Moreover, the atomic concentration of P in the phosphorus compound coating portion was about 4 atm%. The phosphorus compound coating portion had a smaller film thickness than the magnetic powder of Example 1.

FIG. 3B shows the results of a STEM-EDX line analysis of Example 2. In FIG. 3B, a region extending about 4 nm in which the atomic concentration of Nd was higher than that in the base material magnetic powder was observed in the phosphorus compound coating portion. The average of the atomic concentration ratio of Nd to Fe (Nd/Fe) in the region was about 0.45.

### Examples 3 and 4, Comparative Example 2

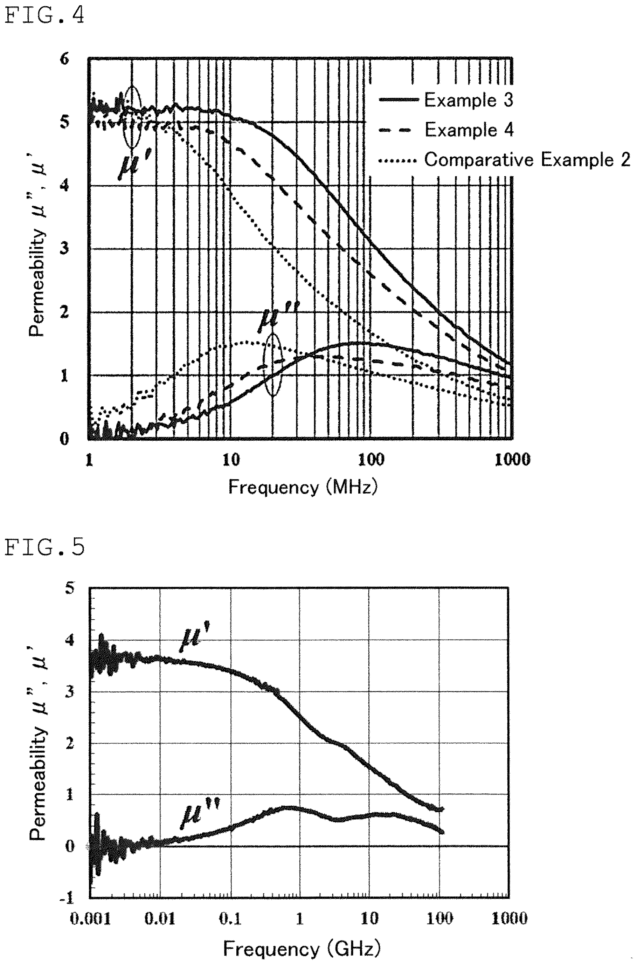

The phosphorus-treated powders of Examples 1 and 2 and the non-phosphorus-treated powder of Comparative Example 1 were used to prepare samples for measuring the complex relative permeability at 1 MHz to 1 GHz as described above (toroidal molded products (amount of added resin: 6% by mass) with densities of 5.76 (Example 3), 5.55 (Example 4), and 5.75 (Comparative Example 2)). The frequency dependences of the complex relative permeability in a range of 1 MHz to 1 GHz were measured as described above, and the results are shown in FIG. 4. The results of the evaluation of the high-frequency characteristics are shown in Table 2.

As shown in FIG. 4, the "ratios of the real part of the relative permeability at 20 MHz to the real part of the relative permeability at 2 MHz" of Example 3, Example 4, and Comparative Example 2 were 0.92, 0.84, and 0.60, respectively. The ratios in Examples 3 and 4 were within the range of 0.8 to 1.1, while the ratio in Comparative Example 2 was lower than 0.8.

**Table 2**

| Example number | Physical properties of bonded magnetic material (permeability) | | | | | |
|---|---|---|---|---|---|---|
| | 2 MHz | | 20 MHz | | | Relative permeability ratio 1) |
| | µ' | µ" | µ' | µ" | µ'/µ" | |
| Example 3 | 5.2 | 0.0 | 4.8 | 1.0 | 4.80 | 0.92 |
| Example 4 | 4.9 | 0.2 | 4.1 | 1.2 | 3.42 | 0.84 |
| Comparative Example 2 | 5.2 | 0.5 | 3.1 | 1.5 | 2.07 | 0.60 |

| | | | | | | |
|---|---|---|---|---|---|---|
| 1) Ratio of real part of relative permeability at 20 MHz to real part of relative permeability at 2 MHz | | | | | | |

### Examples 5 and 6, Comparative Example 3

The phosphorus-treated powders of Examples 1 and 2 and the non-phosphorus-treated powder of Comparative Example 1 were used to prepare samples for measuring the complex relative permeability at 1 MHz or more and 0.11 THz or less as described above (magnetic sheets (amount of added resin: 8% by mass) with densities of 4.96 (Example 5), 4.95 (Example 6), and 4.95 (Comparative Example 3)). The frequency dependence of the complex relative permeability at 1 MHz or more and 0.11 THz or less of Example 5 were measured as described above, and the results are shown in FIG. 5. The results of the evaluation of the high-frequency characteristics of Examples 5 and 6 and Comparative Example 3 are shown in Table 3.

As shown in FIG. 5 and Table 3, the "ratios of the imaginary part of the relative permeability at 0.11 THz to the imaginary part of the relative permeability at 10 GHz" of Examples 5 and 6 and Comparative Example 3 were 0.44, 0.03, and 0.02, respectively. The ratios in Examples 5 and 6 were at least 0.03 but not higher than 5, while the ratio in Comparative Example 3 was lower than 0.03.

**Table 3**

| Example number | Physical properties of bonded magnetic material (permeability) | | | | |
|---|---|---|---|---|---|
| | 10 GHz | | 0.11 THz | | Relative permeability ratio 1) |
| | µ' | µ" | µ' | µ" | |
| Example 5 | 1.55 | 0.59 | 0.72 | 0.26 | 0.44 |
| Example 6 | 1.40 | 0.93 | 0.66 | 0.03 | 0.03 |
| Comparative Example 3 | 1.50 | 0.46 | 0.72 | 0.01 | 0.02 |

| | | | | | |
|---|---|---|---|---|---|
| 1) Ratio of imaginary part of relative permeability at 0.11 THz to imaginary part of relative permeability at 10 GHz | | | | | |

FIG. 5 shows in particular that Example 5 achieved good hyper-high frequency absorption characteristics with an imaginary part µ" of the complex relative permeability of at least 0.2 in a very broad frequency range of 1 GHz to 0.11 THz. In the phosphorus compound-coated rare earth-iron-nitrogen-based magnetic powder according to the present disclosure, the characteristics of planar magnetocrystalline anisotropic materials, which are different from those of uniaxial magnetocrystalline anisotropic materials, were further improved due to the effect of electrical insulation between the powder particles of the phosphorus compound coating portion.

Table 3 shows that the magnetic powder of Example 6 having a phosphorus compound coating portion with a thickness of 20 nm had a higher µ" at 0.11 THz in a hyper-high frequency range than the magnetic powder of the comparative example having an oxygen-rich film with a thickness of about 5 to 10 nm. Moreover, the magnetic powder of Example 5 achieved a further reduction of the eddy current influence partly due to the presence of a phosphorus compound coating portion with a thickness of about 60 nm, and it also had a µ" value as high as 0.26 at 0.11 THz in a hyper-high frequency range. Moreover, at 10 GHz, the µ" of Example 5 was improved compared to that of Comparative Example 3, which is thought to be because the eddy current loss was able to be reduced. In contrast, the magnetic powder of Example 6 had a thinner coating layer than the magnetic powder of Example 5, and the volume fraction of the base material magnetic powder in the magnetic material of Example 6 was high. This is thought to cause improvement of µ" due to natural resonance, and therefore Example 6 showed a larger µ" value than Example 5.

### INDUSTRIAL APPLICABILITY

The production method according to the present disclosure can provide a phosphorus compound-coated rare earth-iron-nitrogen-based magnetic powder having good magnetic field amplification characteristics and hyper-high frequency absorption characteristics. The obtained magnetic powder is suitable for use as a magnetic material for magnetic field amplification and a magnetic material for hyper-high frequency absorption.

The present disclosure includes the following embodiments.

### Aspect 1

A method of producing a magnetic powder, the method comprising
performing a phosphorus treatment to obtain a phosphorus compound and a rare earth-iron-nitrogen-based magnetic powder, the phosphorus treatment comprising
adding an inorganic acid to a slurry comprising:
a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of a total R content;
water; and
a phosphorus-containing substance.

### Aspect 2

The method of producing a magnetic powder according to Aspect 1,
wherein, in the phosphorus treatment, the inorganic acid is added to adjust a pH of the slurry to at least 1 but not higher than 4.5.

### Aspect 3

The method of producing a magnetic powder according to Aspect 1 or 2,
wherein a phosphorus content in the resulting phosphorus compound and rare earth-iron-nitrogen-based magnetic powder is at least 0.02% by mass but not higher than 4% by mass.

### Aspect 4

The method of producing a magnetic powder according to any one of Aspects 1 to 3,
wherein the method comprises, after performing the phosphorus treatment, performing an oxidation comprising heat-treating the resulting phosphorus compound and rare earth-iron-nitrogen-based magnetic powder in an oxygen-containing atmosphere.

### Aspect 5

A magnetic material for magnetic field amplification, comprising:
a phosphorus compound; and
a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of a total R content.

### Aspect 6

The magnetic material for magnetic field amplification according to Aspect 5,
wherein a ratio of a real part of a relative permeability of the magnetic material at 20 MHz to a real part of a relative permeability of the magnetic material at 2 MHz is at least 0.8 but not higher than 1.1.

### Aspect 7

The magnetic material for magnetic field amplification according to Aspect 5 or 6,
wherein a ratio of a real part to an imaginary part of a relative permeability of the magnetic material at 20 MHz is at least 3 but not higher than 10000.

### Aspect 8

The magnetic material for magnetic field amplification according to any one of Aspects 5 to 7,
wherein the phosphorus compound covers a surface of the rare earth-iron-nitrogen-based magnetic powder.

### Aspect 9

The magnetic material for magnetic field amplification according to any one of Aspects 5 to 8,
wherein a phosphorus content with respect to the phosphorus compound and the rare earth-iron-nitrogen-based magnetic powder is at least 0.02% by mass but not higher than 4% by mass.

### Aspect 10

The magnetic material for magnetic field amplification according to any one of Aspects 5 to 9 configured to be used for wireless power transfer.

### Aspect 11

The magnetic material for magnetic field amplification according to any one of Aspects 5 to 10, further comprising a resin in addition to the rare earth-iron-nitrogen-based magnetic powder.

### Aspect 12

A magnetic material for hyper-high frequency absorption, comprising:
a phosphorus compound; and
a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of a total R content.

### Aspect 13

The magnetic material for hyper-high frequency absorption according to Aspect 12,
wherein an imaginary part of a relative permeability of the magnetic material at 0.11 THz is at least 0.02.

### Aspect 14

The magnetic material for hyper-high frequency absorption according to Aspect 12 or 13,
wherein a ratio of an imaginary part of a relative permeability of the magnetic material at 0.11 THz to an imaginary part of a relative permeability of the magnetic material at 10 GHz is at least 0.03.

## Claims

1. A method of producing a magnetic powder, the method comprising
performing a phosphorus treatment to obtain a phosphorus compound and a rare earth-iron-nitrogen-based magnetic powder, the phosphorus treatment comprising
adding an inorganic acid to a slurry comprising:
a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of a total R content;
water; and
a phosphorus-containing substance.

2. The method of producing a magnetic powder according to claim 1,
wherein, in the phosphorus treatment, the inorganic acid is added to adjust a pH of the slurry to at least 1 but not higher than 4.5.

3. The method of producing a magnetic powder according to claim 1 or 2,
wherein a phosphorus content in the resulting phosphorus compound and rare earth-iron-nitrogen-based magnetic powder is at least 0.02% by mass but not higher than 4% by mass.

4. The method of producing a magnetic powder according to any one of claims 1 to 3,
wherein the method comprises, after performing the phosphorus treatment, performing an oxidation comprising heat-treating the resulting phosphorus compound and rare earth-iron-nitrogen-based magnetic powder in an oxygen-containing atmosphere.

5. A magnetic material for magnetic field amplification, comprising:
a phosphorus compound; and
a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of a total R content.

6. The magnetic material for magnetic field amplification according to claim 5,
wherein a ratio of a real part of a relative permeability of the magnetic material at 20 MHz to a real part of a relative permeability of the magnetic material at 2 MHz is at least 0.8 but not higher than 1.1.

7. The magnetic material for magnetic field amplification according to claim 5 or 6,
wherein a ratio of a real part to an imaginary part of a relative permeability of the magnetic material at 20 MHz is at least 3 but not higher than 10000.

8. The magnetic material for magnetic field amplification according to any one of claims 5 to 7,
wherein the phosphorus compound covers a surface of the rare earth-iron-nitrogen-based magnetic powder.

9. The magnetic material for magnetic field amplification according to any one of claims 5 to 8,
wherein a phosphorus content with respect to the phosphorus compound and the rare earth-iron-nitrogen-based magnetic powder is at least 0.02% by mass but not higher than 4% by mass.

10. The magnetic material for magnetic field amplification according to any one of claims 5 to 9 configured to be used for wireless power transfer.

11. The magnetic material for magnetic field amplification according to any one of claims 5 to 10, further comprising a resin in addition to the rare earth-iron-nitrogen-based magnetic powder.

12. A magnetic material for hyper-high frequency absorption, comprising:
a phosphorus compound; and
a rare earth-iron-nitrogen-based magnetic powder containing R, Fe, and N, where R represents at least one selected from the group consisting of Y, Ce, Pr, Nd, Gd, Tb, Dy, Ho, Er, Tm, Lu, and Sm, and if R contains Sm, Sm constitutes less than 50 atm% of a total R content.

13. The magnetic material for hyper-high frequency absorption according to claim 12,
wherein an imaginary part of a relative permeability of the magnetic material at 0.11 THz is at least 0.02.

14. The magnetic material for hyper-high frequency absorption according to claim 12 or 13,
wherein a ratio of an imaginary part of a relative permeability of the magnetic material at 0.11 THz to an imaginary part of a relative permeability of the magnetic material at 10 GHz is at least 0.03.
